# EUROPEAN PATENT APPLICATION

(11) **EP 4 464 759 A2**
(43) Date of publication of application: **20.11.2024**
(21) Application number: 24175751.7
(22) Date of filing: 14.05.2024
(51) Int. Cl.: C09K 11/06, H05B 33/20

(54) **ORGANIC COMPOUNDS AND ORGANIC LIGHT-EMITTING DEVICE COMPRISING THE SAME**

(30) Priority: 16.05.2023 KR 20230063059; 08.05.2024 KR 20240060427
(71) Applicant: SFC Co., Ltd., Cheongju-si, Chungcheongbuk-do 28122 (KR)
(72) Inventor: KIM, Ji-yung, 28122 Chungcheongbuk-do (KR); KIM, Si-in, 28122 Chungcheongbuk-do (KR); KIM, Kyeong-hyeon, 28122 Chungcheongbuk-do (KR); JANG, Hyuk-woo, 28122 Chungcheongbuk-do (KR); CHOI, Do-yeong, 28122 Chungcheongbuk-do (KR); PARK, Seo-youn, 28122 Chungcheongbuk-do (KR); CHOI, Yeon-jae, 28122 Chungcheongbuk-do (KR); KIM, Kyeong-wan, 28122 Chungcheongbuk-do (KR); LEE, Se-jiin, 28122 Chungcheongbuk-do (KR)
(74) Representative: Grosse, Felix Christopher

(57) **Abstract**

Organic compounds represented by Formulas 1 and 2 are disclosed:

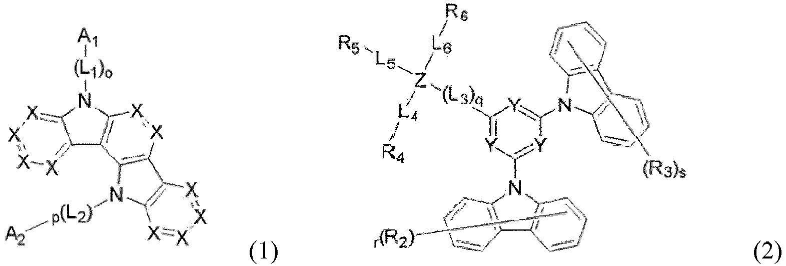

Also disclosed is an organic light emitting device including a light emitting layer employing the organic compounds as host materials. The use of the organic compounds enables low voltage driving of the organic light emitting device and ensures significantly long lifetime and improved luminous efficiency of the device.

## Description

### BACKGROUND OF THE INVENTION

### 1. Field of the Invention

The present invention relates to organic compounds employed in a light emitting layer of an organic light emitting device and an organic light emitting device including the organic compounds.

### 2. Description of the Related Art

Organic light emitting devices are self-luminous devices in which electrons injected from an electron injecting electrode (cathode) recombine with holes injected from a hole injecting electrode (anode) in a light emitting layer to form excitons, which emit light while releasing energy. Such organic light emitting devices have the advantages of low driving voltage, high luminance, large viewing angle, and short response time and can be applied to full-color light emitting flat panel displays. Due to these advantages, organic light emitting devices have received attention as next-generation light sources.

The above characteristics of organic light emitting devices are achieved by structural optimization of organic layers of the devices and are supported by stable and efficient materials for the organic layers, such as hole injecting materials, hole transport materials, hole blocking materials, light emitting materials, electron transport materials, electron injecting materials, and electron blocking materials. However, more research still needs to be done to develop structurally optimized structures of organic layers for organic light emitting devices and stable and efficient materials for organic layers of organic light emitting devices.

Particularly, obtaining maximum efficiency in a light emitting layer requires an appropriate combination of energy band gaps of a host and a dopant such that holes and electrons migrate to the dopant through stable electrochemical paths to form excitons.

### SUMMARY OF THE INVENTION

Therefore, the present invention is intended to provide host materials with a specific structure for a light emitting layer and an organic light emitting device including the host materials that can be driven at low voltage and has significantly long lifetime and improved luminous efficiency.

One aspect of the present invention provides an organic light emitting device including a first electrode, a second electrode opposite to the first electrode, and one or more organic layers interposed between the first and second electrodes wherein one of the organic layers is a light emitting layer including hosts and dopants and at least one of the hosts is selected from organic compounds represented by Formulas 1 and 2:

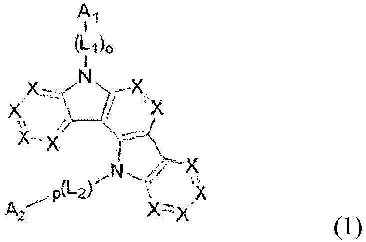

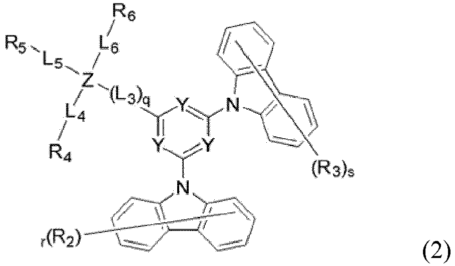

The specific structures of Formulas 1 and 2, definitions of the substituents in Formulas 1 and 2, and specific compounds that can be represented by Formulas 1 and 2 are described below.

One of the organic compounds of the present invention has a structure in which specific moieties are introduced to a specific indolocarbazole-derived skeleton. The other organic compound of the present invention has a structure in which a nitrogen-containing benzene-derived skeleton is substituted with two carbazolyl and silyl or germanium groups. The organic light emitting device of the present invention includes a light emitting layer employing the organic compounds as hosts. The use of the organic compounds enables low voltage driving of the organic light emitting device and ensures significantly long lifetime and improved luminous efficiency of the device. Due to these advantages, the long-lasting and highly efficient organic light emitting device of the present invention can find useful applications in not only lighting systems but also a variety of displays, including flat panel displays, flexible displays, wearable displays, displays for virtual reality, and displays for augmented reality.

### DETAILED DESCRIPTION OF THE INVENTION

The present invention will now be described in more detail.

One aspect of the present invention is directed to an organic light emitting device including a first electrode, a second electrode opposite to the first electrode, and one or more organic layers interposed between the first and second electrodes wherein one of the organic layers is a light emitting layer including hosts and dopants and at least one of the hosts is selected from organic compounds represented by Formulas 1 and 2: 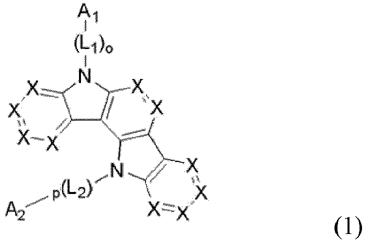
wherein the moieties X are the same as or different from each other and are each independently N or CR₁, the groups R₁ are the same as or different from each other and are each independently selected from hydrogen, deuterium, substituted or unsubstituted C₁-C₃₀ alkyl, substituted or unsubstituted C₆-C₅₀ aryl, substituted or unsubstituted C₂-C₅₀ heteroaryl, and cyclic groups in which a substituted or unsubstituted C₃-C₃₀ aliphatic ring and a C₅-C₃₀ aromatic ring are fused together, with the proviso that adjacent ones of the groups R₁ are optionally linked to each other to form an alicyclic or aromatic monocyclic or polycyclic ring, A₁ and A₂ are the same as or different from each other and are each independently selected from substituted or unsubstituted C₆-C₅₀ aryl, substituted or unsubstituted C₂-C₅₀ heteroaryl, and cyclic groups in which a substituted or unsubstituted C₃-C₃₀ aliphatic ring and a C₅-C₃₀ aromatic ring are fused together, L₁ and L₂ are the same as or different from each other and each independently represent a single bond or are each independently selected from substituted or unsubstituted C₆-C₃₀ arylene, substituted or unsubstituted C₂-C₃₀ heteroarylene, and divalent cyclic groups in which a substituted or unsubstituted C₃-C₂₄ aliphatic ring and a C₅-C₂₄ aromatic ring are fused together, o and p are each independently an integer of 1 or 2, provided that when o and p are integers greater than or equal to 2, the linkers L₁ and L₂ are the same as or different from each other, respectively, 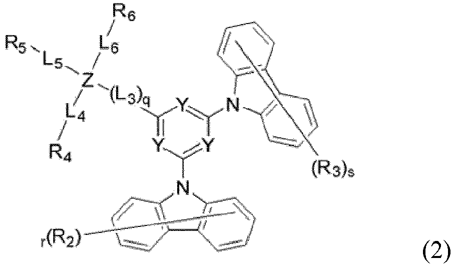
wherein the moieties Y are the same as or different from each other and are each independently N or CR₇, with the proviso that at least one of the moieties Y is N, Z is Si or Ge, R₂ to R₆ are the same as or different from each other and are each independently selected from hydrogen, deuterium, substituted or unsubstituted C₁-C₃₀ alkyl, substituted or unsubstituted C₆-C₅₀ aryl, substituted or unsubstituted C₂-C₅₀ heteroaryl, and cyclic groups in which a substituted or unsubstituted C₃-C₃₀ aliphatic ring and a C₅-C₃₀ aromatic ring are fused together, r and s are integers of 8, the groups R₂ and R₃ are the same as or different from each other, respectively, with the proviso that adjacent ones of the groups R₂ are optionally linked to each other to form an alicyclic or aromatic monocyclic or polycyclic ring, with the proviso that adjacent ones of the groups R₃ are optionally linked to each other to form an alicyclic or aromatic monocyclic or polycyclic ring, L₃ to L₆ are the same as or different from each other and each independently represent a single bond or are each independently selected from substituted or unsubstituted C₆-C₃₀ arylene, substituted or unsubstituted C₂-C₃₀ heteroarylene, and divalent cyclic groups in which a substituted or unsubstituted C₃-C₂₄ aliphatic ring and a C₅-C₂₄ aromatic ring are fused together, q is an integer of 1 or 2, provided that when q is an integer greater than or equal to 2, the linkers L₃ are the same as or different from each other.

The term "substituted" in the definitions of X, A₁, A₂, and L₁ and L₂ in Formula 1 and Y, R₂ to R₆, and L₃ to L₆ in Formula 2 indicates substitution with one or more substituents selected from deuterium, C₁-C₂₄ alkyl, C₁-C₂₄ haloalkyl, C₂-C₂₄ alkenyl, C₂-C₂₄ alkynyl, C₃-C₃₀ cycloalkyl, C₁-C₂₄ heteroalkyl, C₆-C₃₀ aryl, C₇-C₃₀ arylalkyl, C₇-C₃₀ alkylaryl, C₂-C₃₀ heteroaryl, C₂-C₃₀ heteroarylalkyl, C₂-C₃₀ heteroarylalkyl, cyclic groups in which a substituted or unsubstituted C₃-C₂₄ aliphatic ring and a C₅-C₂₄ aromatic ring are fused together, C₁-C₂₄ alkoxy, C₁-C₃₀ amine, C₁-C₃₀ silyl, C₁-C₃₀ germanium, C₆-C₂₄ aryloxy, C₆-C₂₄ arylthionyl, cyano, halogen, hydroxyl, and nitro, or a combination thereof. When substituted with two or more substituents, the substituents may be identical to or different from each other. The term "unsubstituted" in the same definition indicates having no substituent. One or more hydrogen atoms in each of the substituents are optionally replaced by deuterium atoms.

According to one embodiment of the present invention, the moieties X in Formula 1 may be all CR₁.

According to one embodiment of the present invention, the moieties Y in Formula 2 may be all N.

According to one embodiment of the present invention, Z in Formula 2 may be Si.

According to one embodiment of the present invention, q in Formula 2 may be an integer of 1 and L₃ in Formula 2 may be substituted or unsubstituted C₆-C₂₀ arylene.

According to one embodiment of the present invention, R₄ to R₆ in Formula 2 may be the same as or different from each other and may be each independently substituted or unsubstituted C₆-C₂₀ aryl.

According to one embodiment of the present invention, the organic compound represented by Formula 1 may be deuterated.

According to one embodiment of the present invention, the organic compound represented by Formula 2 may be deuterated.

According to one embodiment of the present invention, the organic compounds represented by Formulas 1 and 2 may be used as hosts that emit blue phosphorescence.

According to one embodiment of the present invention, one of the dopants may be at least one organometallic compound.

The dopant compounds employed in the light emitting layer of the organic light emitting device according to the present invention are not fluorescent dopant materials that are transferred only to singlet states based on Forster energy transfer in traditional host-dopant systems but phosphorescent dopant materials that are transferred to both singlet and triplet states irrespective of whether their state based on Dexter energy transfer. The phosphorescent dopant materials are metal complexes containing at least one metal selected from Ir, Pt, Os, Ti, Zr, Hf, Eu, Tb, Tm, Fe, Co, Ni, Ru, Rh, Re, and Pd but are not particularly limited thereto as long as they emit light from triplet excitons.

The metal is preferably selected from Ir, Pt, and Pd and specific examples of the metal complexes include, but are not limited to, Ir(ppy)₃, Ir(ppy)₂acac, Ir(Bt)₂acac, Ir(MDQ)₂acac, Ir(mppy)₃, Ir(piq)₃, Ir(piq)₂acac, Ir(pq)₂acac, Ir(mpp)₂acac, F₂Irpic, (F₂ppy)₂Ir(tmd), Ir(ppy)₂tmd, Ir(pmi)₃, Ir(pmb)₃, FCNIr, FCNIrpic, FIr₆, FIrN₄, FIrpic, PtOEP, Ir(chpy)₃, P0-01(C₃₁H₂₃IrN₂O₂S₂), Ir(ppz)₃, Ir(dfppz)₃, PtNON, Pt-10, and Pt-11.

According to one embodiment of the present invention, the organometallic compound may be mixed or stacked with one or more other dopants. One of the additional dopants may be a polycyclic compound represented by Formula 3: 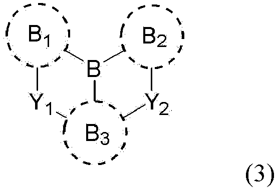 wherein Y₁ and Y₂ are the same as or different from each other and are each independently selected from O, S, NR₁₁, CR₁₂R₁₃, SiR₁₄R₁₅, and GeR₁₆R₁₇, B₁ to B₃ are the same as or different from each other and are each independently selected from substituted or unsubstituted C₆-C₃₀ aromatic hydrocarbon rings, substituted or unsubstituted C₃-C₃₀ aliphatic hydrocarbon rings, substituted or unsubstituted C₂-C₃₀ aromatic heterocyclic rings, substituted or unsubstituted C₂-C₃₀ aliphatic heterocyclic rings, and cyclic groups in which a substituted or unsubstituted C₃-C₂₄ aliphatic ring and a C₅-C₂₄ aromatic ring are fused together, R₁₁ to R₁₇ are the same as or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, cyclic groups in which a substituted or unsubstituted C₃-C₃₀ aliphatic ring and a C₅-C₃₀ aromatic ring are fused together, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted germanium, nitro, cyano, and halogen, with the proviso that each of R₁₁ to R₁₇ is optionally linked to one or more of the B₁ to B₃ rings to form an alicyclic or aromatic monocyclic or polycyclic ring, R₁₂ and R₁₃ are optionally linked to each other to form an alicyclic or aromatic monocyclic or polycyclic ring, R₁₄ and R₁₅ are optionally linked to each other to form an alicyclic or aromatic monocyclic or polycyclic ring, and R₁₆ and R₁₇ are optionally linked to each other to form an alicyclic or aromatic monocyclic or polycyclic ring.

The term "substituted" in the definitions of Y₁, Y₂, and B₁ to B₃ in Formula 3 indicates substitution with one or more substituents selected from deuterium, C₁-C₂₄ alkyl, C₂-C₂₄ alkenyl, C₂-C₂₄ alkynyl, C₃-C₃₀ cycloalkyl, C₁-C₂₄ heteroalkyl, C₆-C₃₀ aryl, C₇-C₃₀ arylalkyl, C₇-C₃₀ alkylaryl, C₂-C₃₀ heteroaryl, C₂-C₃₀ heteroarylalkyl, cyclic groups in which a substituted or unsubstituted C₃-C₂₄ aliphatic ring and a C₅-C₂₄ aromatic ring are fused together, C₁-C₂₄ alkoxy, C₁-C₃₀ amine, C₁-C₃₀ silyl, C₁-C₃₀ germanium, C₆-C₂₄ aryloxy, C₆-C₂₄ arythionyl, cyano, halogen, hydroxyl, and nitro, or a combination thereof. When substituted with two or more substituents, the substituents may be identical to or different from each other. The term "unsubstituted" in the same definition indicates having no substituent. One or more hydrogen atoms in each of the substituents are optionally replaced by deuterium atoms.

The light emitting layer may further include a dopant material. In this case, the total content of the dopants in the light emitting layer is typically in the range of about 0.01 to about 20 parts by weight, based on about 100 parts by weight of the hosts but is not limited to this range.

The light emitting layer may further include one or more other dopant materials and one or more other hosts. Thus, two or more different dopant materials and two or more different host materials may be mixed or stacked in the light emitting layer.

Accordingly, according to one embodiment of the present invention, the light emitting layer of the organic light emitting device may include a first host, a second host, an organometallic compound, and the polycyclic compound (thermally activated delayed boron-based fluorescent material) of Formula 3.

The organometallic compound functions as a sensitizer and the polycyclic compound functions as a light emitting dopant. The sensitizer compound receives excitons from the first host and the second host and transfer the excitons to the light emitting dopant.

Accordingly, excitons are transferred from the sensitizer to the light emitting dopant compound through the Dexter energy transfer (DET) or Forster resonance transfer (FRET) mechanism, and the exciton energy delivered to the light emitting dopant compound is transferred to the ground state. In this process, the energy is emitted as light. The excitons can be transferred from the first and second hosts to the sensitizer through the FRET or DET mechanism.

In conclusion, the FRET or DET mechanism facilitates energy transfer between the sensitizer and the light emitting dopant and suppresses triplet-triplet annihilation, ensuring high efficiency of the organic light emitting device.

Forster energy transfer from the triplet of the phosphorescence sensitizer to the singlet of the polycyclic compound (thermally activated delayed boron-based fluorescent material) represented by Formula 3, contributes to a reduction in the number of long-lived triplet excitons involved in the degradation of the device, ensuring long lifetime of the device.

In addition, the high molar extinction coefficient of the polycyclic compound ensures fast fluorescence resonance energy transfer from the phosphorescence sensitizer to the fluorescent material and the multiple resonance effect of the polycyclic compound narrows the emission spectrum to increase the color purity of the device, achieving improved efficiency and lifetime of the device.

In this embodiment, the organic compound represented by Formula 1 is a host compound that has an indolocarbazole moiety as an electron donor moiety. The organic compound represented by Formula 2 is a host compound that has an aromatic heterocyclic azine moiety containing nitrogen as an electron acceptor moiety. The mixing and stacking of the host compounds increase the HOMO/LUMO levels of hole injection and electron injection barriers, and as a result, the recombination zone is limited to the interface of the host compounds, leading to minimal current loss. Due to this advantage, the organic light emitting device can be driven at low voltage and has high efficiency and long lifetime.

The organic layers of the organic light emitting device according to the present invention may form a monolayer structure. Alternatively, the organic layers may be stacked together to form a multilayer structure. For example, the organic layers may have a structure including a hole injecting layer, a hole transport layer, a hole blocking layer, a light emitting layer, an electron blocking layer, an electron transport layer, and an electron injecting layer but are not limited to this structure. The number of the organic layers is not limited and may be increased or decreased. Preferred structures of the organic layers of the organic light emitting device according to the present invention will be explained in more detail in the Examples section that follows.

In the "substituted or unsubstituted C₁-C₃₀ alkyl", "substituted or unsubstituted C₆-C₅₀ aryl", etc., the number of carbon atoms in the alkyl or aryl group indicates the number of carbon atoms constituting the unsubstituted alkyl or aryl moiety without considering the number of carbon atoms in the substituent(s). For example, a phenyl group substituted with a butyl group at the para-position corresponds to a C₆ aryl group substituted with a C₄ butyl group.

As used herein, the expression "optionally linked to each other or an adjacent group to form a ring" means that the corresponding adjacent substituents are bonded to each other or each of the corresponding substituents is bonded to an adjacent group to form a substituted or unsubstituted alicyclic or aromatic ring. The term "adjacent group" may mean a substituent on an atom directly attached to an atom substituted with the corresponding substituent, a substituent disposed sterically closest to the corresponding substituent or another substituent on an atom substituted with the corresponding substituent. For example, two substituents substituted at the ortho position of a benzene ring or two substituents on the same carbon in an aliphatic ring may be considered "adjacent" to each other. Optionally, the paired substituents each lose one hydrogen radical and are linked to each other to form a ring. The carbon atoms in the resulting alicyclic, aromatic mono- or polycyclic ring may be replaced by one or more heteroatoms such as N, NR, O, S, Si, and Ge.

In the present invention, the alkyl groups may be straight or branched. Specific examples of the alkyl groups include, but are not limited to, methyl, ethyl, propyl, n-propyl, isopropyl, butyl, n-butyl, isobutyl, tert-butyl, sec-butyl, 1-methylbutyl, 1-ethylbutyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethylpropyl, 1,1-dimethylpropyl, isohexyl, 2-methylpentyl, 4-methylhexyl, and 5-methylhexyl groups.

In the present invention, specific examples of the arylalkyl groups include, but are not limited to, phenylmethyl(benzyl), phenylethyl, phenylpropyl, naphthylmethyl, and naphthylethyl.

In the present invention, specific examples of the alkylaryl groups include, but are not limited to, tolyl, xylenyl, dimethylnaphthyl, t-butylphenyl, t-butylnaphthyl, and t-butylphenanthryl.

The alkenyl group is intended to include straight and branched ones and may be optionally substituted with one or more other substituents. The alkenyl group may be specifically a vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, stilbenyl or styrenyl group but is not limited thereto.

The alkynyl group is intended to include straight and branched ones and may be optionally substituted with one or more other substituents. The alkynyl group may be, for example, ethynyl or 2-propynyl but is not limited thereto.

The cycloalkenyl group is a non-aromatic cyclic unsaturated hydrocarbon group having one or more carbon-carbon double bonds. The cycloalkenyl group may be, for example, cyclopropenyl, cyclobutenyl, cyclopentenyl, cyclohexenyl, cycloheptenyl, 1,3-cyclohexadienyl, 1,4-cyclohexadienyl, 2,4-cycloheptadienyl or 1,5-cyclooctadienyl but is not limited thereto.

The aromatic hydrocarbon rings or aryl groups may be monocyclic or polycyclic ones. As used herein, the term "polycyclic" means that the aromatic hydrocarbon ring may be directly attached or fused to one or more other cyclic groups. The other cyclic groups may be aromatic hydrocarbon rings and other examples thereof include aliphatic heterocyclic rings, aliphatic hydrocarbon rings, and aromatic heterocyclic rings. Examples of the monocyclic aryl groups include, but are not limited to, phenyl, biphenyl, and terphenyl. Examples of the polycyclic aryl groups include naphthyl, anthracenyl, phenanthrenyl, pyrenyl, perylenyl, tetracenyl, chrysenyl, fluorenyl, acenaphathcenyl, triphenylene, and fluoranthrene groups but the scope of the present invention is not limited thereto.

The aromatic heterocyclic rings or heteroaryl groups refer to aromatic groups containing one or more heteroatoms such as O, S, N, P, Si, and Ge. Examples of the aromatic heterocyclic rings or heteroaryl groups include, but are not limited to, thiophene, furan, pyrrole, imidazole, thiazole, oxazole, oxadiazole, triazole, pyridyl, bipyridyl, pyrimidyl, triazine, triazole, acridyl, pyridazine, pyrazinyl, quinolinyl, quinazoline, quinoxalinyl, phthalazinyl, pyridopyrimidinyl, pyridopyrazinyl, pyrazinopyrazinyl, isoquinoline, indole, carbazole, benzoxazole, benzimidazole, benzothiazole, benzocarbazole, benzothiophene, dibenzothiophene, benzofuranyl, dibenzofuranyl, phenanthroline, thiazolyl, isoxazolyl, oxadiazolyl, thiadiazolyl, benzothiazolyl, and phenothiazinyl groups.

The aliphatic hydrocarbon rings or cycloalkyl groups refer to non-aromatic rings consisting only of carbon and hydrogen atoms. The aliphatic hydrocarbon ring is intended to include monocyclic and polycyclic ones and may be optionally substituted with one or more other substituents. As used herein, the term "polycyclic" means that the aliphatic hydrocarbon ring may be directly attached or fused to one or more other cyclic groups. The other cyclic groups may be aliphatic hydrocarbon rings and other examples thereof include aliphatic heterocyclic rings, aromatic hydrocarbon rings, and aromatic heterocyclic rings. Specific examples of the aliphatic hydrocarbon rings include, but are not limited to, cycloalkyl groups such as cyclopropyl, cyclobutyl, cyclopentyl, adamantyl, bicycloheptanyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, and cyclooctyl, cycloalkanes such as cyclohexane and cyclopentane, and cycloalkenes such as cyclohexene and cyclobutene.

The aliphatic heterocyclic rings or heterocycloalkyl groups refer to aliphatic rings containing one or more heteroatoms such as O, S, Se, N, Si, and Ge. The aliphatic heterocyclic ring is intended to include monocyclic or polycyclic ones and may be optionally substituted with one or more other substituents. As used herein, the term "polycyclic" means that the aliphatic heterocyclic ring such as heterocycloalkyl or heterocycloalkane may be directly attached or fused to one or more other cyclic groups. The other cyclic groups may be aliphatic heterocyclic rings and other examples thereof include aliphatic hydrocarbon rings, aromatic hydrocarbon rings, and aromatic heterocyclic rings.

The cyclic group(s) in which an aliphatic ring and an aromatic ring are fused together refers to a mixed aliphatic-aromatic cyclic group(s) in which two or more rings are linked and fused together and which are overall non-aromatic. More specifically, the cyclic group(s) in which an aliphatic ring and an aromatic ring are fused together may be an aromatic hydrocarbon cyclic group(s) fused with an aliphatic hydrocarbon ring, an aromatic hydrocarbon cyclic group(s) fused with an aliphatic heterocyclic ring, an aromatic heterocyclic group(s) fused with an aliphatic hydrocarbon ring, an aromatic hydrocarbon cyclic group(s) fused with an aliphatic heterocyclic ring, an aliphatic heterocyclic group(s) fused with an aromatic hydrocarbon ring, an aliphatic hydrocarbon cyclic group(s) fused with an aliphatic heterocyclic ring, an aliphatic heterocyclic group(s) fused with an aromatic hydrocarbon ring or an aliphatic heterocyclic group(s) fused with an aromatic heterocyclic ring. Specific examples of the cyclic group(s) in which an aliphatic ring and an aromatic ring are fused together include tetrahydronaphthyl, tetrahydrobenzocycloheptene, tetrahydrophenanthrene, tetrahydroanthracenyl, octahydrotriphenylene, tetrahydrobenzothiophene, tetrahydrobenzofuranyl, tetrahydrocarbazole, and tetrahydroquinoline. The cyclic group(s) in which an aliphatic ring and an aromatic ring are fused together may be interrupted by at least one heteroatom other than carbon. The heteroatom may be, for example, O, S, N, P, Si or Ge.

The alkoxy group may be specifically a methoxy, ethoxy, propoxy, isobutyloxy, sec-butyloxy, pentyloxy, iso-amyloxy or hexyloxy group but is not limited thereto.

The silyl group is intended to include -SiH₃, alkylsilyl, arylsilyl, alkylarylsilyl, arylheteroarylsilyl, and heteroaryl silyl. The arylsilyl refers to a silyl group obtained by substituting one, two or three of the hydrogen atoms in -SiH₃ with aryl groups. The alkylsilyl refers to a silyl group obtained by substituting one, two or three of the hydrogen atoms in -SiH₃ with alkyl groups. The alkylarylsilyl refers to a silyl group obtained by substituting one of the hydrogen atoms in -SiH₃ with an alkyl group and the other two hydrogen atoms with aryl groups or substituting two of the hydrogen atoms in -SiH₃ with alkyl groups and the remaining hydrogen atom with an aryl group. The arylheteroaryl silyl refers to a silyl group obtained by substituting one of the hydrogen atoms in -SiH₃ with an aryl group and the other two hydrogen atoms with heteroaryl groups or substituting two of the hydrogen atoms in -SiH₃ with aryl groups and the remaining hydrogen atom with a heteroaryl group. The heteroaryl silyl refers to a silyl group obtained by substituting one, two or three of the hydrogen atoms in -SiH₃ with heteroaryl groups. The arylsilyl group may be, for example, substituted or unsubstituted monoarylsilyl, substituted or unsubstituted diarylsilyl, or substituted or unsubstituted triarylsilyl. The same applies to the alkylsilyl and heteroarylsilyl groups.

Each of the aryl groups in the aryl silyl, heteroarylsilyl, and arylheteroarylsilyl groups may be a monocyclic or polycyclic one. Each of the heteroaryl groups in the arylsilyl, heteroarylsilyl, and arylheteroarylsilyl groups may be a monocyclic or polycyclic one.

Specific examples of the silyl groups include trimethylsilyl, triethylsilyl, triphenylsilyl, trimethoxysilyl, dimethoxyphenylsilyl, diphenylmethylsilyl, diphenylvinylsilyl, methylcyclobutylsilyl, and dimethylfurylsilyl. One or more of the hydrogen atoms in each of the silyl groups may be substituted with the substituents mentioned in the aryl groups.

The amine group is intended to include -NH₂, alkylamine, arylamine, arylheteroarylamine, and heteroarylamine. The arylamine refers to an amine group obtained by substituting one or two of the hydrogen atoms in -NH₂ with aryl groups. The alkylamine refers to an amine group obtained by substituting one or two of the hydrogen atoms in -NH₂ with alkyl groups. The alkylarylamine refers to an amine group obtained by substituting one of the hydrogen atoms in -NH₂ with an alkyl group and the other hydrogen atom with an aryl group. The arylheteroarylamine refers to an amine group obtained by substituting one of the hydrogen atoms in -NH₂ with an aryl group and the other hydrogen atom with a heteroaryl group. The heteroarylamine refers to an amine group obtained by substituting one or two of the hydrogen atoms in -NH₂ with heteroaryl groups. The arylamine may be, for example, substituted or unsubstituted monoarylamine, substituted or unsubstituted diarylamine, or substituted or unsubstituted triarylamine. The same applies to the alkylamine and heteroarylamine groups.

Each of the aryl groups in the arylamine, heteroarylamine, and arylheteroarylamine groups may be a monocyclic or polycyclic one. Each of the heteroaryl groups in the arylamine, heteroarylamine, and arylheteroarylamine groups may be a monocyclic or polycyclic one.

The germanium group is intended to include -GeH₃, alkylgermanium, aryl germanium, heteroarylgermanium, alkylarylgermanium, alkylheteroarylgermanium, and arylheteroarylgermanium. The definitions of the substituents in the germanium groups follow those described for the silyl groups, except that the silicon (Si) atom in each silyl group is changed to a germanium (Ge) atom.

Specific examples of the germanium groups include trimethylgermane, triethylgermane, triphenylgermane, trimethoxygermane, dimethoxyphenylgermane, diphenylmethylgermane, diphenylvinylgermane, methylcyclobutylgermane, and dimethylfurylgermane. One or more of the hydrogen atoms in each of the germanium groups may be substituted with the substituents mentioned in the aryl groups.

The cycloalkyl, aryl, and heteroaryl groups in the cycloalkyloxy, aryloxy, heteroaryloxy, cycloalkylthioxy, arylthioxy, and heteroarylthioxy groups are the same as those exemplified above. Specific examples of the aryloxy groups include, but are not limited to, phenoxy, p-tolyloxy, m-tolyloxy, 3,5-dimethylphenoxy, 2,4,6-trimethylphenoxy, p-tert-butylphenoxy, 3-biphenyloxy, 4-biphenyloxy, 1-naphthyloxy, 2-naphthyloxy, 4-methyl-1-naphthyloxy, 5-methyl-2-naphthyloxy, 1-anthryloxy, 2-anthryloxy, 9-anthryloxy, 1-phenanthryloxy, 3-phenanthryloxy, and 9-phenanthryloxy groups. Specific examples of the arylthioxy groups include, but are not limited to, phenylthioxy, 2-methylphenylthioxy, and 4-tert-butylphenylthioxy groups.

The halogen group may be, for example, fluorine, chlorine, bromine or iodine.

According to one embodiment of the present invention, the compound represented by Formula 1 may be selected from the following compounds:

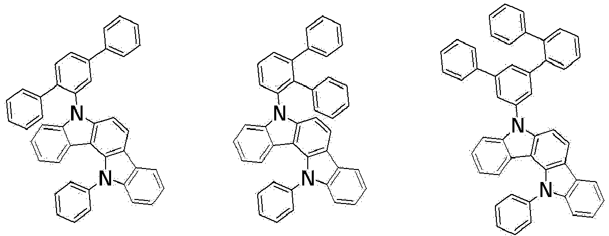

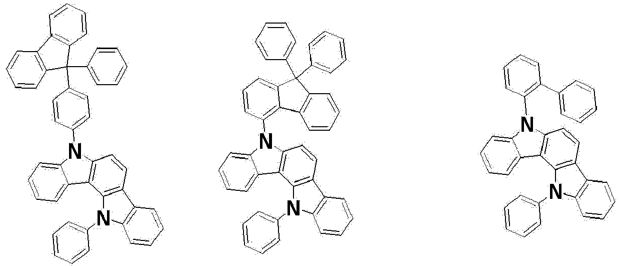

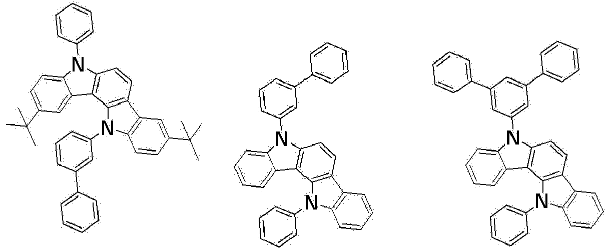

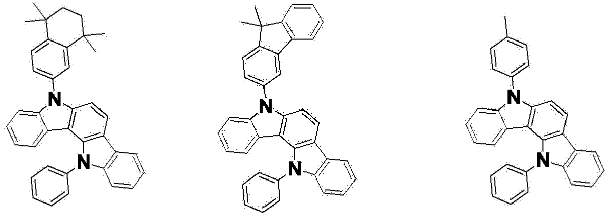

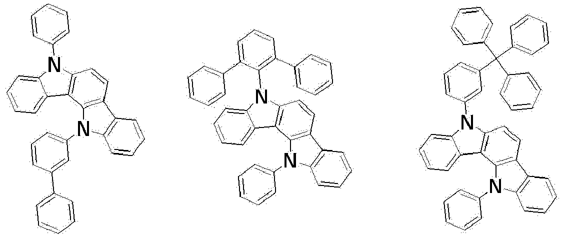

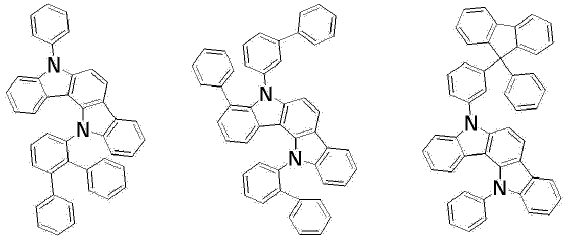

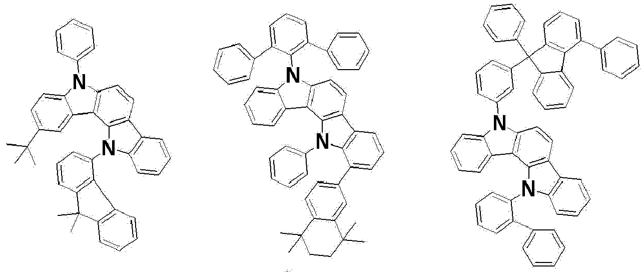

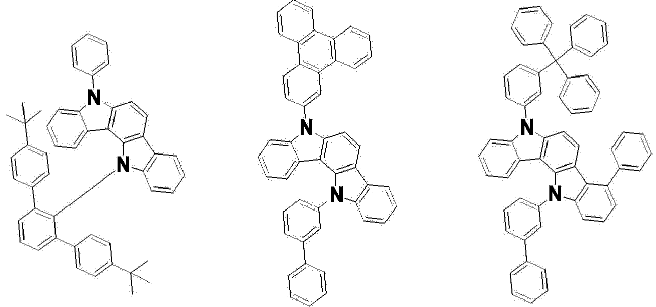

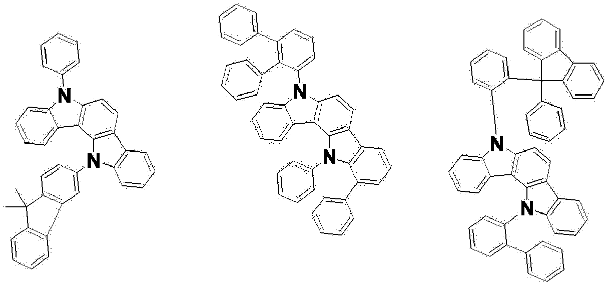

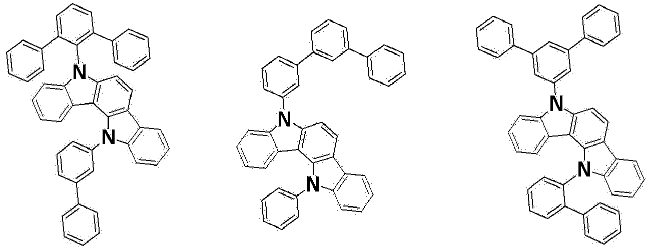

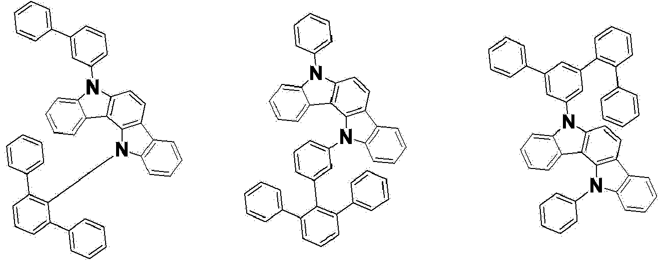

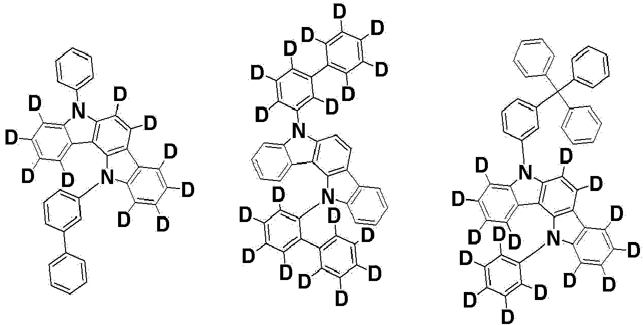

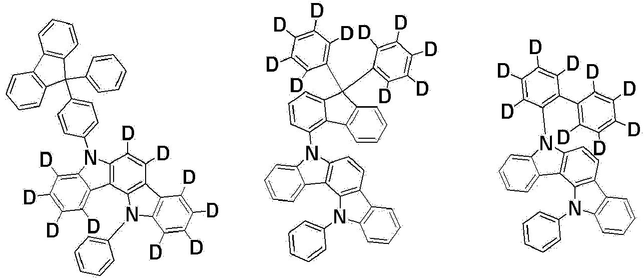

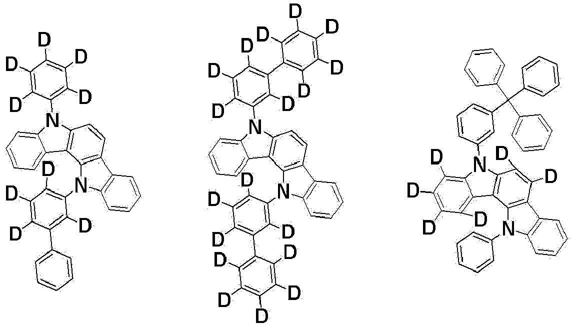

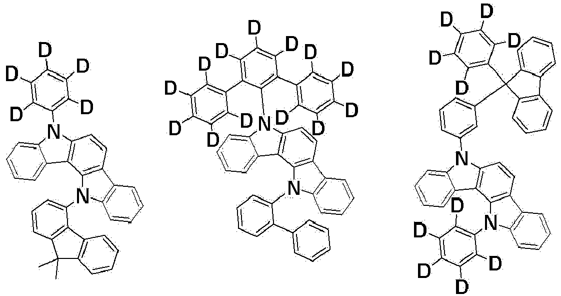

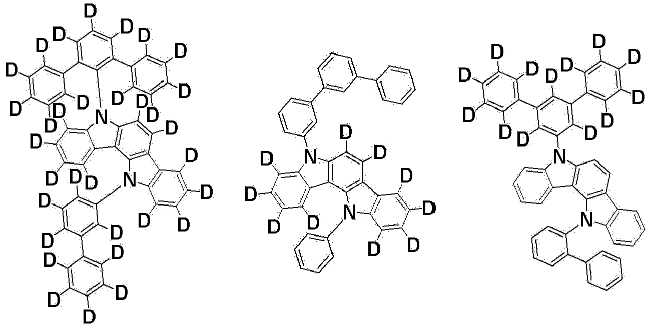

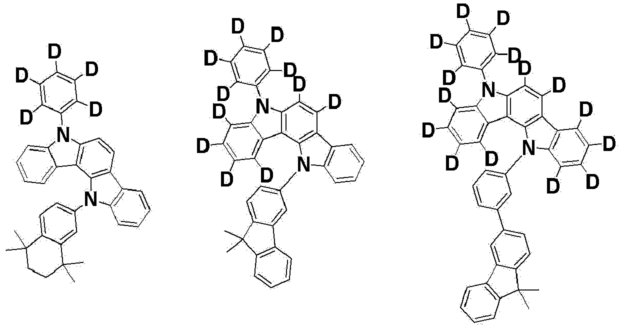

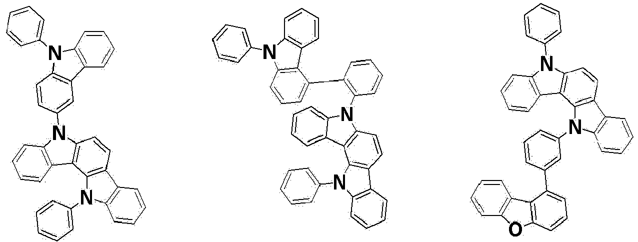

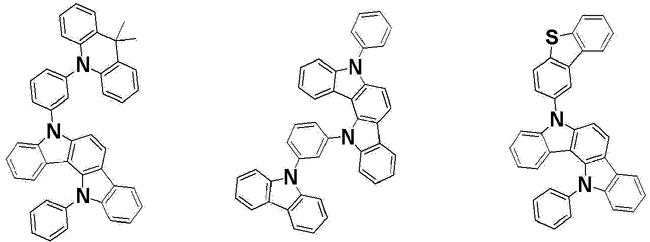

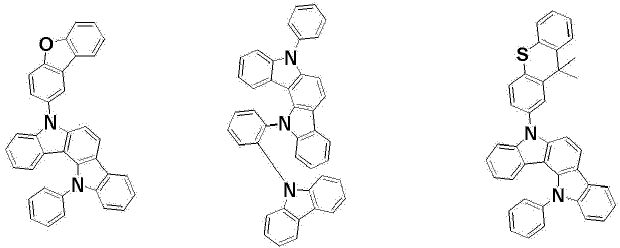

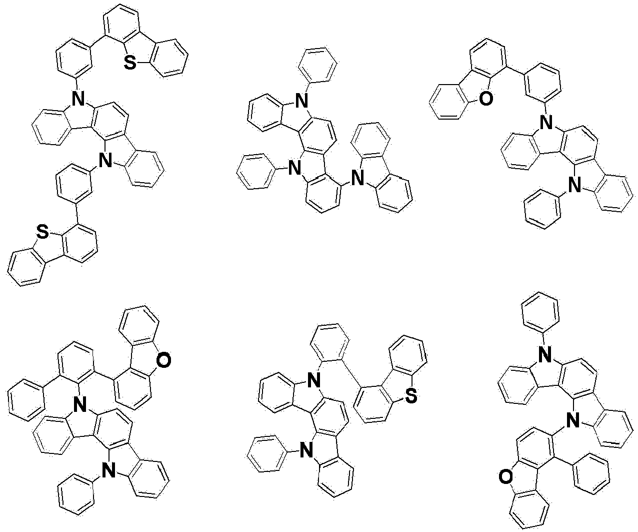

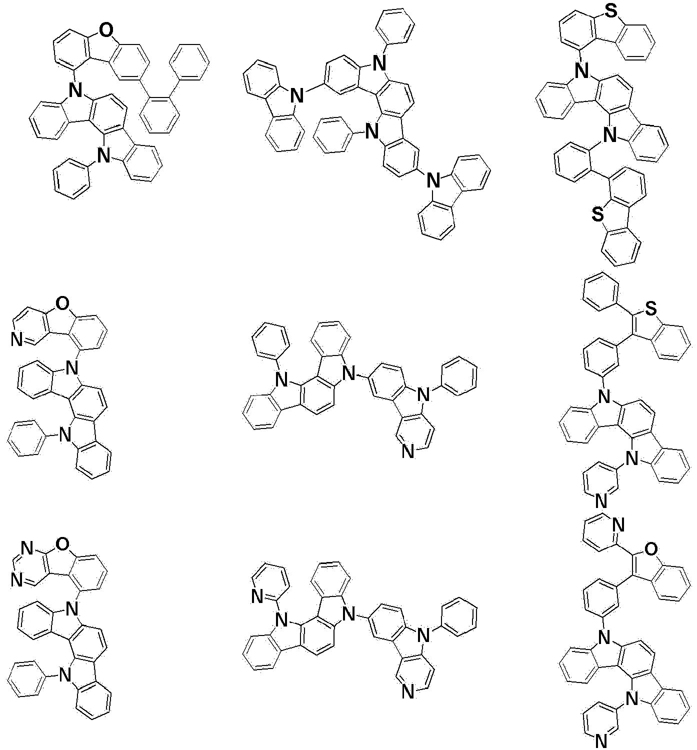

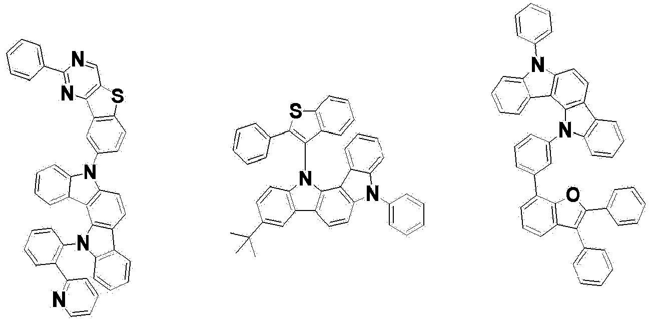

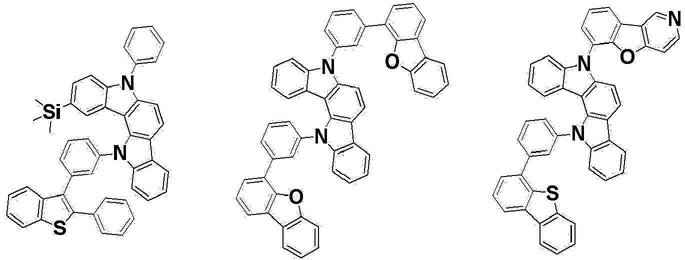

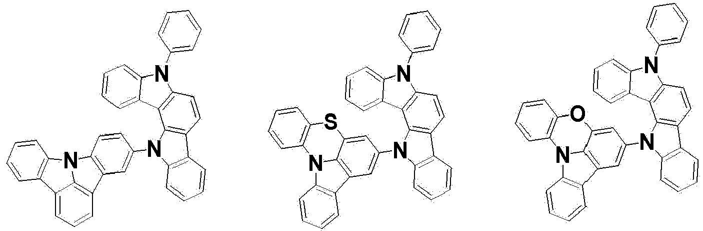

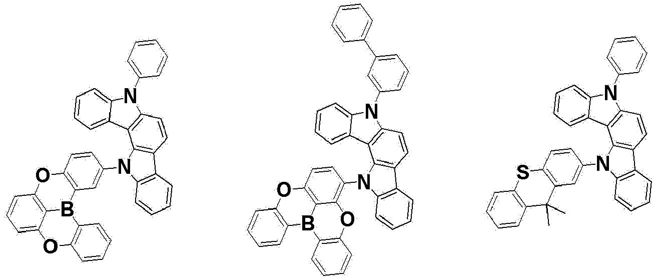

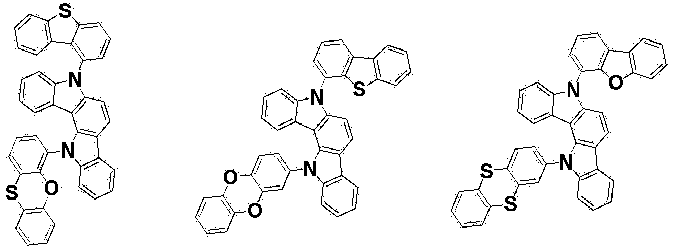

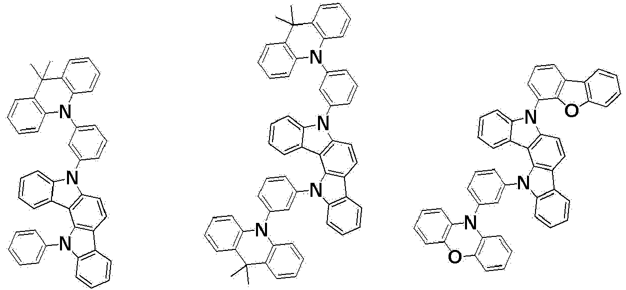

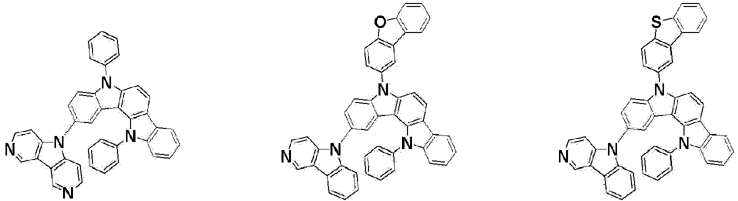

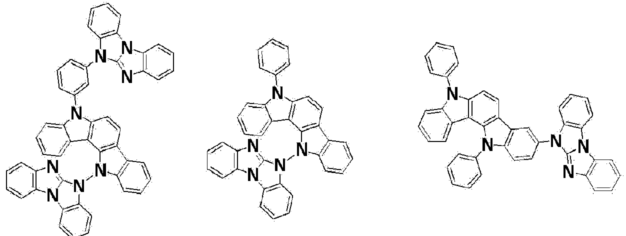

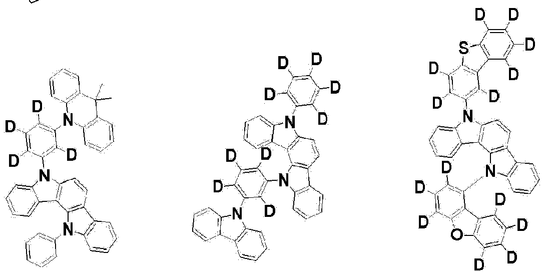

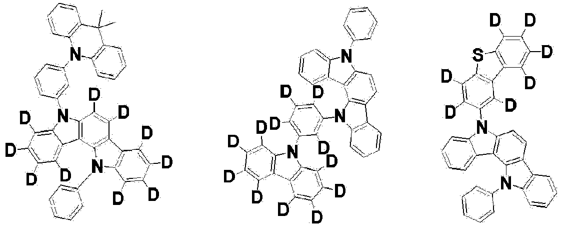

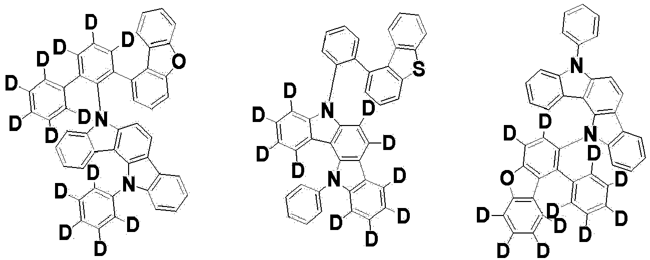

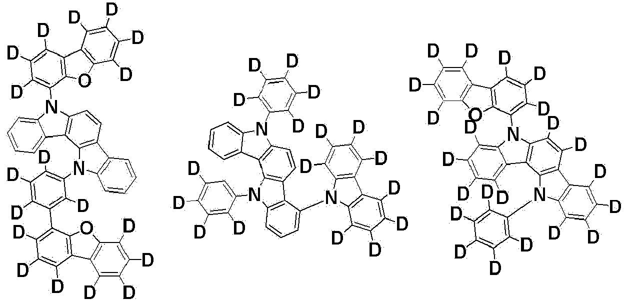

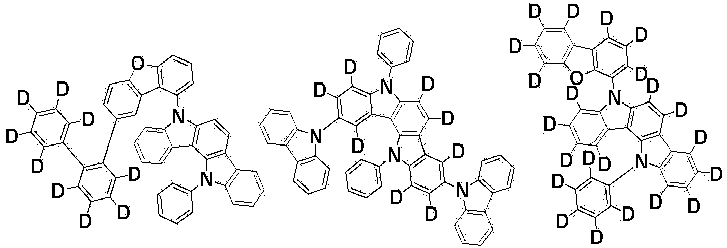

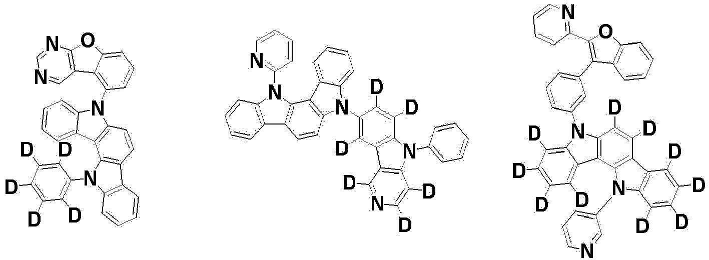

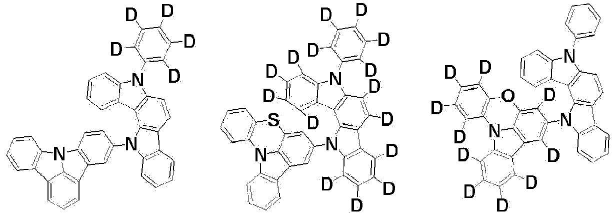

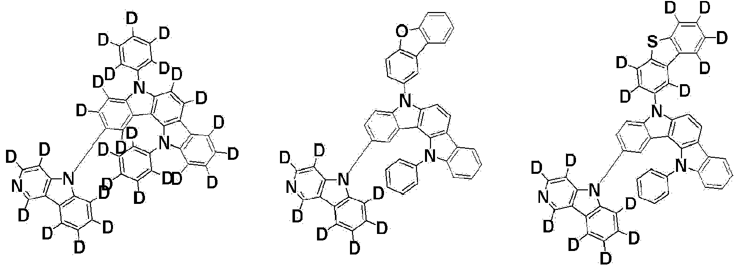

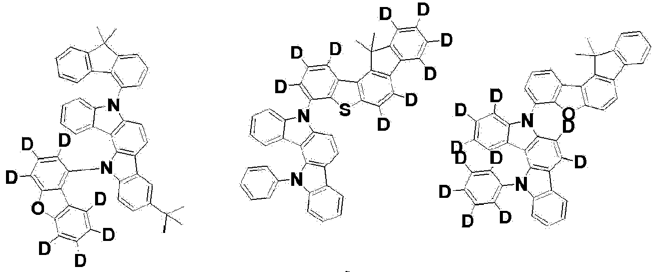

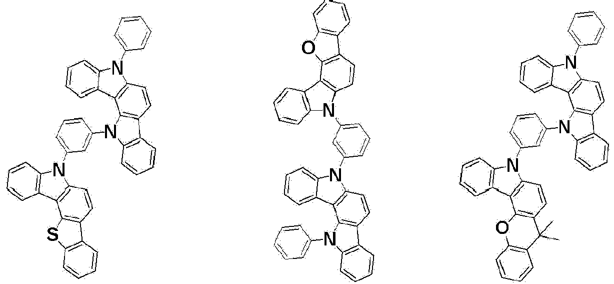

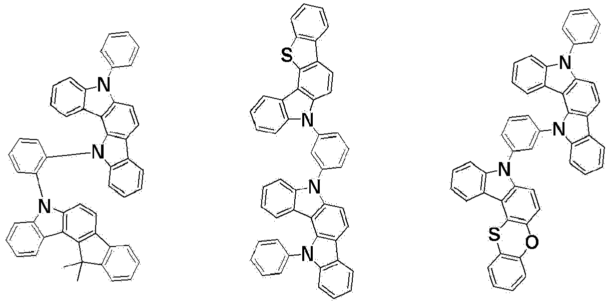

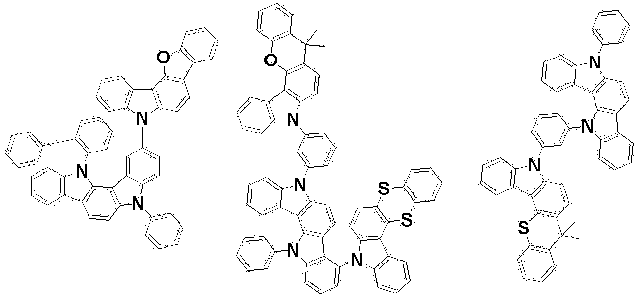

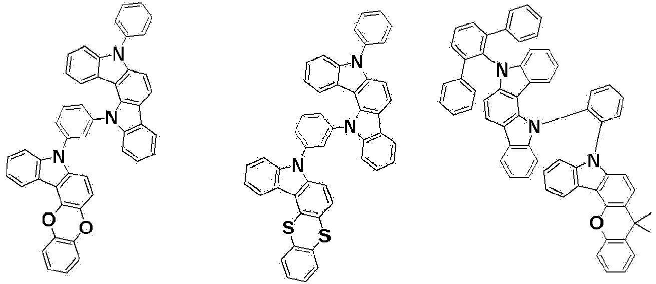

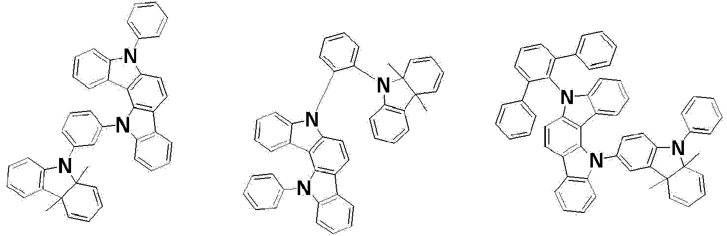

However, these compounds are not intended to limit the scope of Formula 1.

According to one embodiment of the present invention, the compound represented by Formula 2 may be selected from the following compounds:

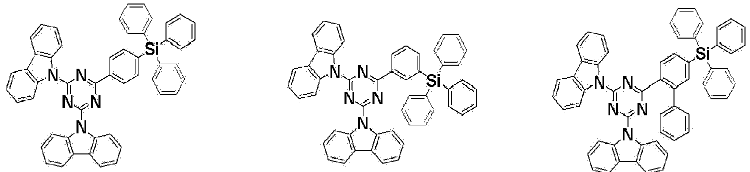

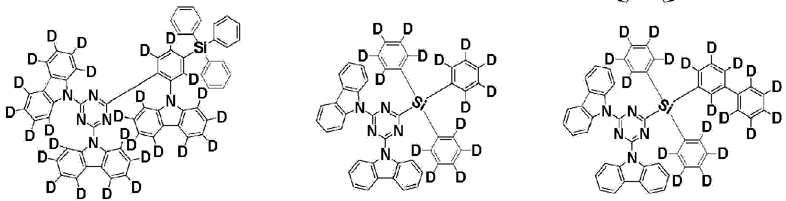

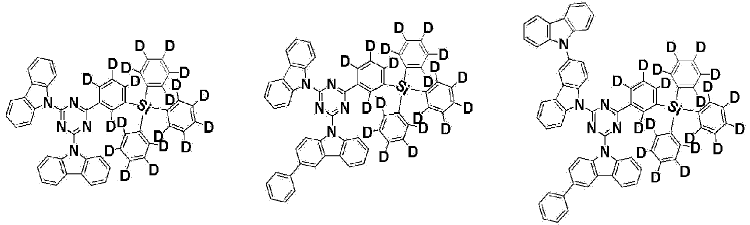

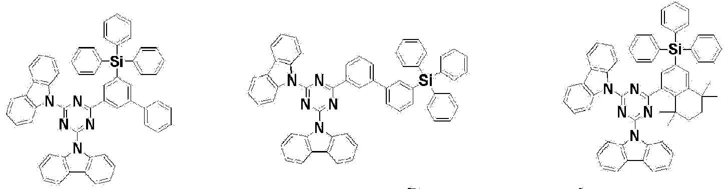

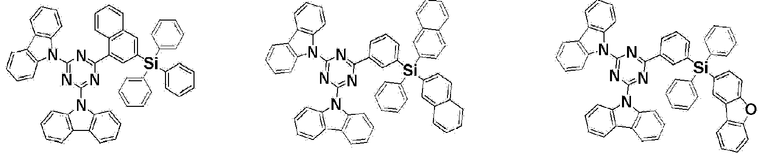

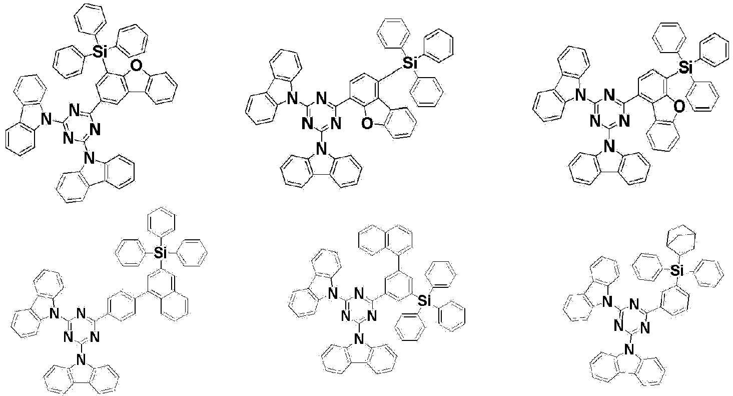

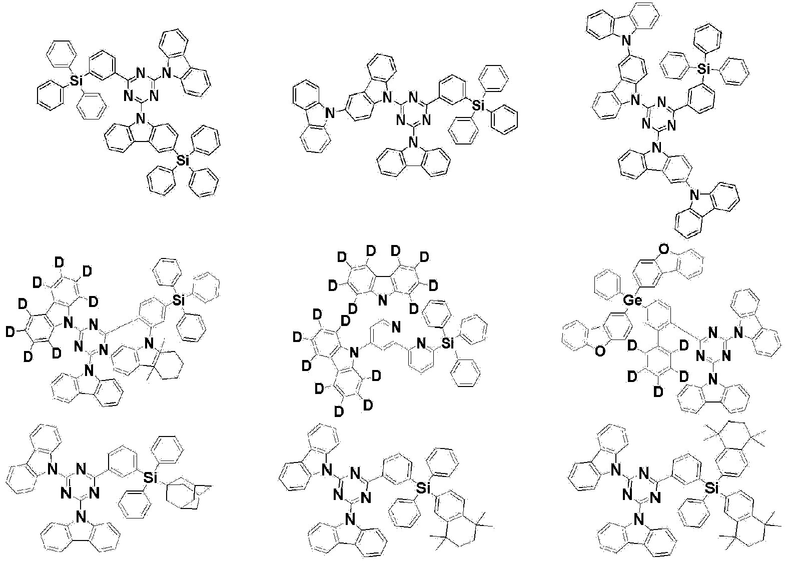

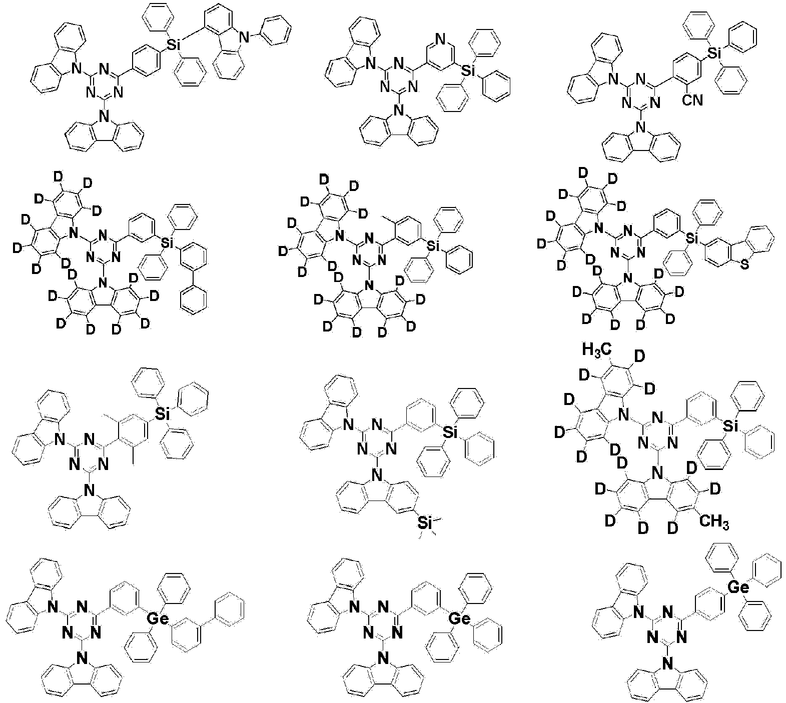

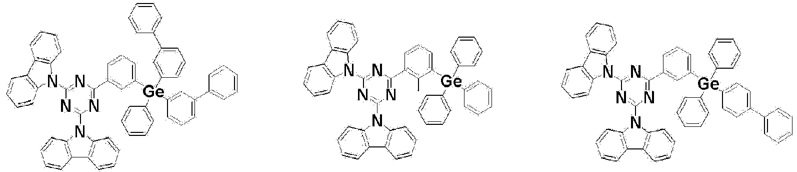

However, these compounds are not intended to limit the scope of Formula 2.

A more detailed description will be given concerning exemplary embodiments of the organic light emitting device according to the present invention.

The organic light emitting device of the present invention includes an anode, a hole transport layer, a light emitting layer, an electron transport layer, and a cathode. The organic light emitting device of the present invention may optionally further include a hole injecting layer between the anode and the hole transport layer and an electron injecting layer between the electron transport layer and the cathode. If necessary, the organic light emitting device of the present invention may further include one or two intermediate layers such as a hole blocking layer or an electron blocking layer. The organic light emitting device of the present invention may further include one or more organic layers such as a capping layer that have various functions depending on the desired characteristics of the device.

A specific structure of the organic light emitting device according to one embodiment of the present invention, a method for fabricating the device, and materials for the organic layers are as follows.

First, an anode material is coated on a substrate to form an anode. The substrate may be any of those used in general organic light emitting devices. The substrate is preferably an organic substrate or a transparent plastic substrate that is excellent in transparency, surface smoothness, ease of handling, and waterproofness. A highly transparent and conductive metal oxide such as indium tin oxide (ITO), indium zinc oxide (IZO), tin oxide (SnO₂) or zinc oxide (ZnO) is used as the anode material.

A hole injecting material is coated on the anode by vacuum thermal evaporation or spin coating to form a hole injecting layer. Then, a hole transport material is coated on the hole injecting layer by vacuum thermal evaporation or spin coating to form a hole transport layer.

The hole injecting material is not specially limited so long as it is usually used in the art. Specific examples of such materials include 1,4,5,8,9,11-hexaazatriphenylenehexacarbonitrile (HAT-CN), 4,4',4"-tris(2-naphthylphenyl-phenylamino)triphenylamine (2-TNATA), N,N'-di(1-naphthyl)-N,N'-diphenylbenzidine (NPD), N,N'-diphenyl-N,N'-bis(3-methylphenyl)-1,1'-biphenyl-4,4'-diamine (TPD), and N,N'-diphenyl-N,N'-bis(4-(phenyl-m-tolylamino)phenyl)biphenyl-4,4'-diamine (DNTPD).

The hole transport material is not specially limited so long as it is commonly used in the art. Examples of such materials include N,N'-bis(3-methylphenyl)-N,N'-diphenyl-(1,1-biphenyl)-4,4'-diamine (TPD) and N,N'-di(naphthalen-1-yl)-N,N'-diphenylbenzidine (α-NPD).

Subsequently, a hole auxiliary layer and a light emitting layer are sequentially stacked on the hole transport layer. A hole blocking layer may be optionally formed on the light emitting layer by vacuum thermal evaporation or spin coating. The hole blocking layer is formed as a thin film and blocks holes from entering a cathode through the organic light emitting layer. This role of the hole blocking layer prevents the lifetime and efficiency of the device from deteriorating. A material having a very low highest occupied molecular orbital (HOMO) energy level is used for the hole blocking layer. The hole blocking material is not particularly limited so long as it can transport electrons and has a higher ionization potential than the light emitting compound. Representative examples of suitable hole blocking materials include BAlq, BCP, and TPBI.

Examples of materials for the hole blocking layer include, but are not limited to, BAlq, BCP, Bphen, TPBI, TAZ, BeBq₂, OXD-7, and Liq.

An electron transport layer is deposited on the hole blocking layer by vacuum thermal evaporation or spin coating, and an electron injecting layer is formed thereon. A cathode metal is deposited on the electron injecting layer by vacuum thermal evaporation to form a cathode, completing the fabrication of the organic light emitting device.

For example, lithium (Li), magnesium (Mg), aluminum (Al), aluminum-lithium (Al-Li), calcium (Ca), magnesium-indium (Mg-In) or magnesium-silver (Mg-Ag) may be used as the metal for the formation of the cathode. The organic light emitting device may be of top emission type. In this case, a transmissive material such as ITO or IZO may be used to form the cathode.

A material for the electron transport layer functions to stably transport electrons injected from the cathode. The electron transport material may be any of those known in the art and examples thereof include, but are not limited to, quinoline derivatives, particularly tris(8-quinolinolato)aluminum (Alq₃), TAZ, BAlq, beryllium bis(benzoquinolin-10-olate) (Bebq₂), and oxadiazole derivatives such as PBD, BMD, and BND.

The organic light emitting device of the present invention may further include a light emitting layer composed of a material that emits blue, green or red light in the wavelength range of 380 nm to 800 nm. That is, the organic light emitting device of the present invention may include a plurality of light emitting layers. The blue, green or red light emitting material for the additional light emitting layer may be a fluorescent or phosphorescent material.

Each of the organic layers can be formed by a monomolecular deposition or solution process. According to the monomolecular deposition process, the material for each layer is evaporated into a thin film under heat and vacuum or reduced pressure. According to the solution process, the material for each layer is mixed with a suitable solvent and the mixture is then formed into a thin film by a suitable method such as inkjet printing, roll-to-roll coating, screen printing, spray coating, dip coating or spin coating.

The organic light emitting device of the present invention can be used in a display or lighting system selected from flat panel displays, flexible displays, monochromatic flat panel lighting systems, white flat panel lighting systems, flexible monochromatic lighting systems, flexible white lighting systems, displays for automotive applications, displays for virtual reality, and displays for augmented reality.

The present invention will be more specifically explained with reference to the following synthesis examples and fabrication examples. However, these examples are provided to assist in understanding the invention and are not intended to limit the scope of the present invention.

### Synthesis Example 1. Synthesis of HT-1

### Synthesis Example 1-1: Synthesis of HT-1

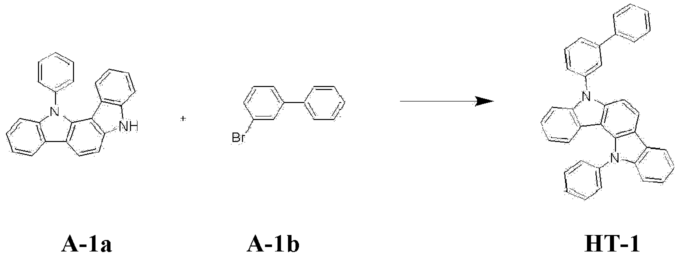

15 g of **A-1a** and 11.6 g of **A-lb,** 0.8 g of Pd₂(dba)₃, 6.5 g of STB, and 150 mL of toluene were heated with stirring in a round bottom flask under a nitrogen atmosphere. When the temperature reached 40 °C, 0.7 g of P(t-Bu)₃ was added, followed by reflux. After completion of the reaction, the reaction mixture was allowed to stand for layer separation. The organic layer was concentrated under reduced pressure and purified by column chromatography to afford **HT-1** (10 g, 49%).
MS (MALDI-TOF): m/z 484.19 [M⁺]

### Synthesis Example 2: Synthesis of HT-2

### Synthesis Example 2-1: Synthesis of HT-2

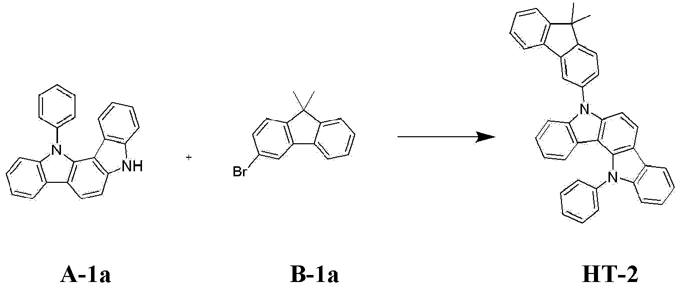

**HT-2** (yield 62%) was synthesized in the same manner as in Synthesis Example 1-1, except that B-1a was used instead of A-1b.
MS (MALDI-TOF): m/z 524.23 [M⁺]

### Synthesis Example 3: Synthesis of HT-3

### Synthesis Example 3-1: Synthesis of C-1

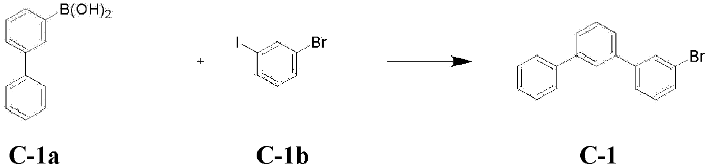

30 g of **C-1a,** 47.1 g of **C-1b,** 5.25 g of Pd(pph₃)₄, 31.41 g of K₂CO₃, 150 mL of toluene, 90 mL of tetrahydrofuran, and 90 mL of water were refluxed with stirring in a round bottom flask for 6 h. After completion of the reaction, the reaction mixture was allowed to stand for layer separation. The organic layer was concentrated under reduced pressure and purified by column chromatography to afford **C-1** (28 g, 59%).

### Synthesis Example 3-2: Synthesis of HT-3

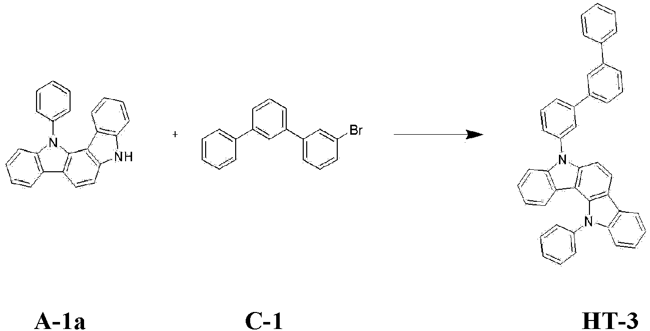

**HT-3** (yield 54%) was synthesized in the same manner as in Synthesis Example 1-1, except that C-1 was used instead of A-1b.
MS (MALDI-TOF): m/z 560.23 [M⁺]

### Synthesis Example 4: Synthesis of HT-4

### Synthesis Example 4-1: Synthesis of HT-4

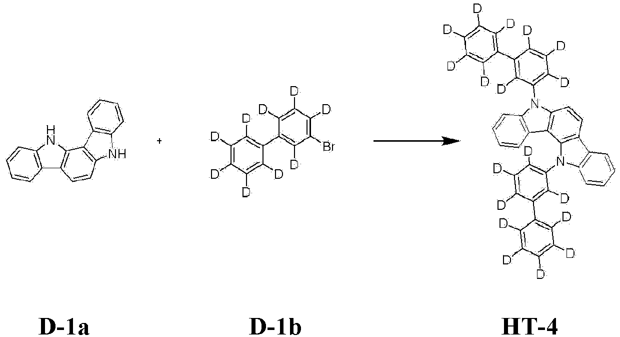

15 g of D-1a, 31.2 g of D-1b, 0.8 g of Pd₂(dba)₃, 16.5 g of STB, and 250 mL of toluene were heated with stirring in a round bottom flask under a nitrogen atmosphere. When the temperature reached 40 °C, 1.8 g of P(t-Bu)₃ was added, followed by reflux. After completion of the reaction, the reaction mixture was allowed to stand for layer separation. The organic layer was concentrated under reduced pressure and purified by column chromatography to afford **HT-4** (13 g, 39%).
MS (MALDI-TOF): m/z 578.34 [M⁺]

### Synthesis Example 5: Synthesis of HT-5

### Synthesis Example 5-1: Synthesis of HT-5

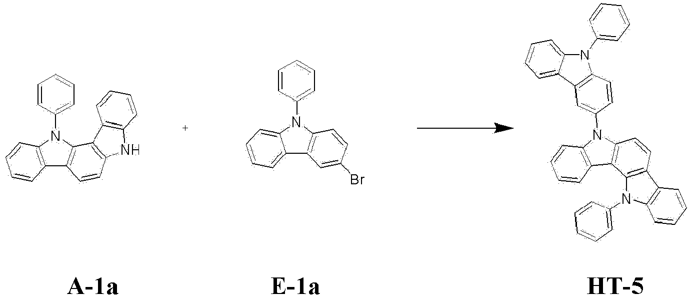

**HT-5** (yield 51%) was synthesized in the same manner as in Synthesis Example 1-1, except that **E-1a** was used instead of **A-1b.**
MS (MALDI-TOF): m/z 573.22 [M⁺]

### Synthesis Example 6: Synthesis of HT-6

### Synthesis Example 6-1: Synthesis of HT-6

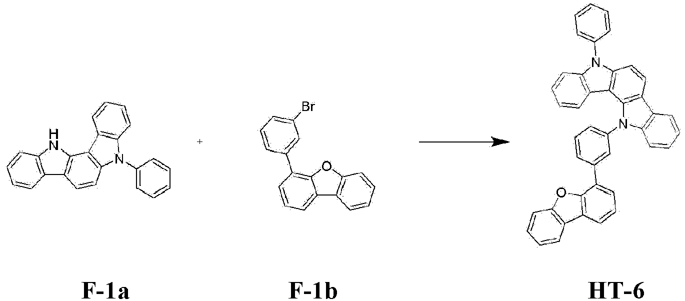

**HT-6** (yield 58%) was synthesized in the same manner as in Synthesis Example 1-1, except that F-1a and **F-1b** were used instead of **A-1a** and **A-1b,** respectively.
MS (MALDI-TOF): m/z 574.20 [M⁺]

### Synthesis Example 7: Synthesis of HT-7

### Synthesis Example 7-1: Synthesis of HT-7

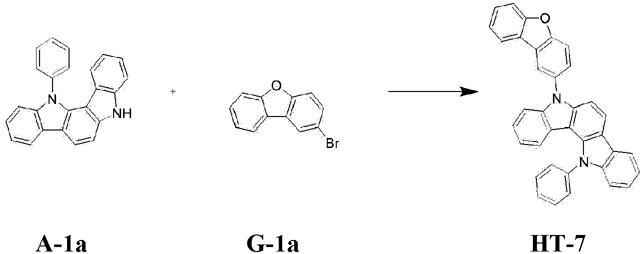

**HT-7** (yield 63%) was synthesized in the same manner as in Synthesis Example 1-1, except that **G-1a** was used instead of **A-1b.**
MS (MALDI-TOF): m/z 498.17 [M⁺]

### Synthesis Example 8: Synthesis of HT-8

### Synthesis Example 8-1: Synthesis of HT-8

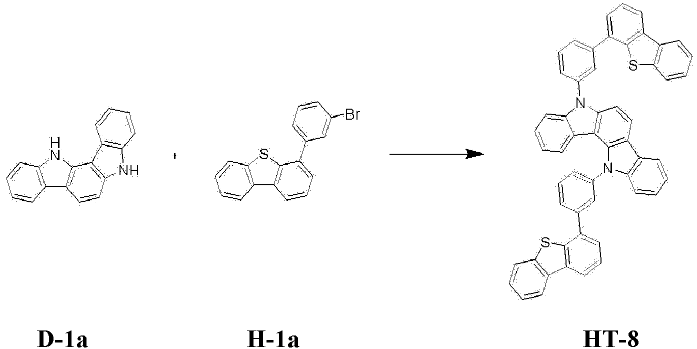

**HT-8** (yield 49%) was synthesized in the same manner as in Synthesis Example 1-1, except that **D-1a** and **H-1a** were used instead of **A-1a** and **A-lb,** respectively.
MS (MALDI-TOF): m/z 772.20 [M⁺]

### Synthesis Example 9: Synthesis of HT-9

### Synthesis Example 9-1: Synthesis of I-1

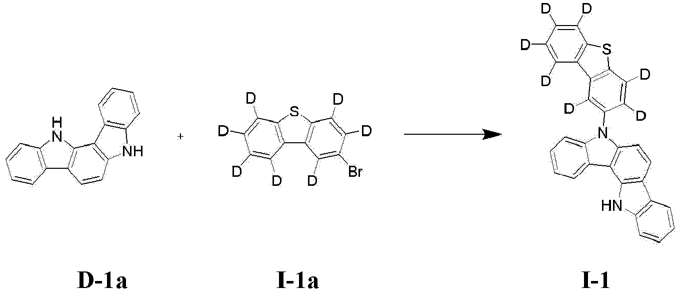

**I-1** (yield 56%) was synthesized in the same manner as in Synthesis Example 1-1, except that **D-1a** and **I-1a** were used instead of **A-1a** and **A-1b,** respectively.

### Synthesis Example 9-2: Synthesis of HT-9

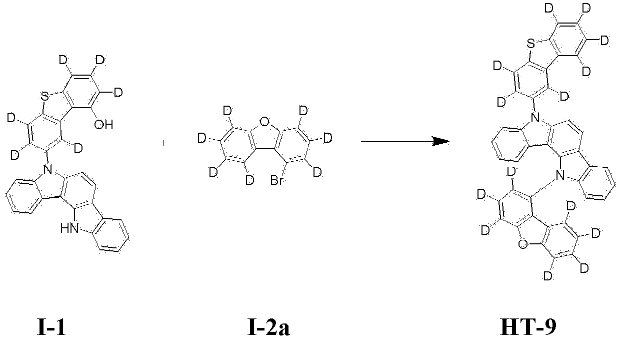

**HT-9** (yield 63%) was synthesized in the same manner as in Synthesis Example 1-1, except that **I-1** and I-2a were used instead of **A-1a** and **A-1b,** respectively.
MS (MALDI-TOF): m/z 618.25 [M⁺]

### Synthesis Example 10: Synthesis of HT-10

### Synthesis Example 10-1: Synthesis of J-1

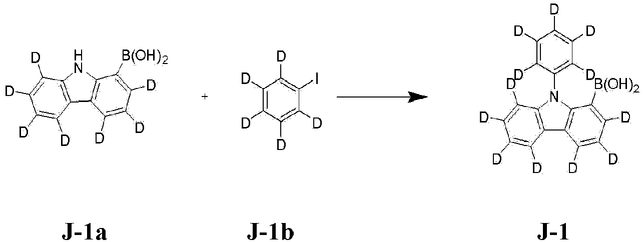

**J-1** (yield 59%) was synthesized in the same manner as in Synthesis Example 1-1, except that **J-1a** and **J-1b** were used instead of **A-1a** and **A-lb,** respectively.

### Synthesis Example 10-2: Synthesis of J-2

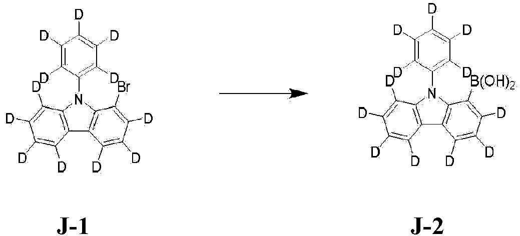

20 g of **J-1** was added to 160 mL of THF in a round bottom flask. The mixture was cooled to -78 °C under a nitrogen atmosphere. After slow dropwise addition of 37 mL of n-BuLi, stirring was performed for 30 min. After 1 h, the resulting mixture was added with 10 mL of trimethyl borate and the temperature was raised to room temperature with stirring. After completion of the reaction, the reaction mixture was allowed to stand for layer separation. The organic layer was concentrated under reduced pressure and purified by column chromatography to afford **J-2** (13 g, 73%).

### Synthesis Example 10-3: Synthesis of J-3

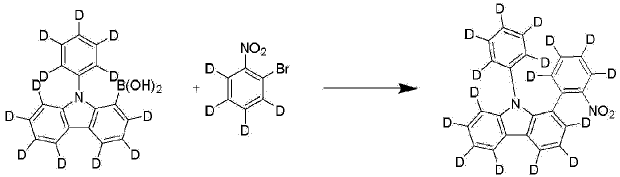

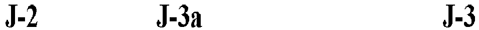

**J-3** (yield 69%) was synthesized in the same manner as in Synthesis Example 3-1, except that **J-2** and **J-3a** were used instead of **C-1a** and **C-1b,** respectively.

### Synthesis Example 10-3: Synthesis of J-4

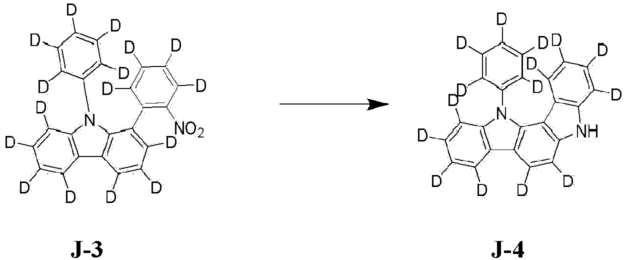

50 g of **J-3,** 105 g of triphenylphosphine, and 500 mL of dichlorobenzene were refluxed in a round bottom flask under a nitrogen atmosphere and. After completion of the reaction, the reaction mixture was allowed to stand for layer separation. The organic layer was concentrated under reduced pressure and purified by column chromatography to afford **J-4** (34 g, 75%).

### Synthesis Example 10-5: Synthesis of HT-10

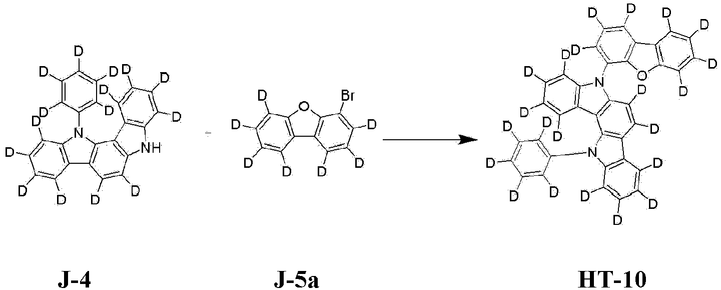

**HT-10** (yield 63%) was synthesized in the same manner as in Synthesis Example 1-1, except that **J-4** and **J-5a** were used instead of **A-1a** and **A-1b,** respectively.
MS (MALDI-TOF): m/z 520.31 [M⁺]

### Synthesis Example 11: Synthesis of ET-1

### Synthesis Example 11-1: Synthesis of ET-1

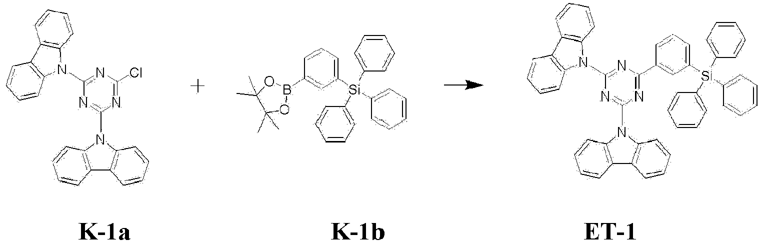

**ET-1** (yield 65%) was synthesized in the same manner as in Synthesis Example 3-1, except that **K-1a** and **K-1b** were used instead **of C-1a** and **C-1b,** respectively.
MS (MALDI-TOF): m/z 745.27 [M⁺]

### Synthesis Example 12: Synthesis of ET-2

### Synthesis Example 12-1: Synthesis of ET-2

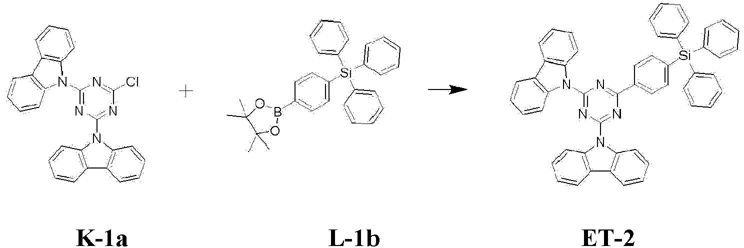

**ET-2** (yield 49%) was synthesized in the same manner as in Synthesis Example 3-1, except that **L-1b** and **K-1a** were used instead of **C-1a** and **C-1b,** respectively.
MS (MALDI-TOF): m/z 745.27 [M⁺]

### Synthesis Example 13: Synthesis of ET-3

### Synthesis Example 13-1: Synthesis of ET-3

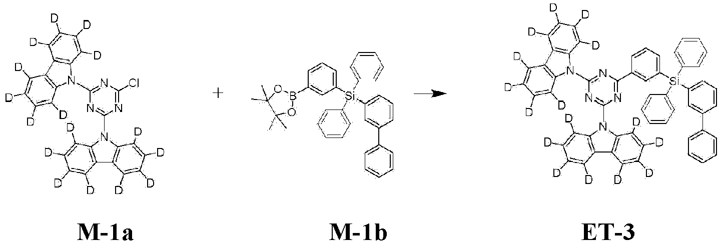

**ET-3** (yield 55%) was synthesized in the same manner as in Synthesis Example 3-1, except that **M-1b** and **M-1a** were used instead of **C-1a** and **C-1b,** respectively.
MS (MALDI-TOF): m/z 837.40 [M⁺]

### Synthesis Example 14: Synthesis of ET-4

### Synthesis Example 14-1: Synthesis of ET-4

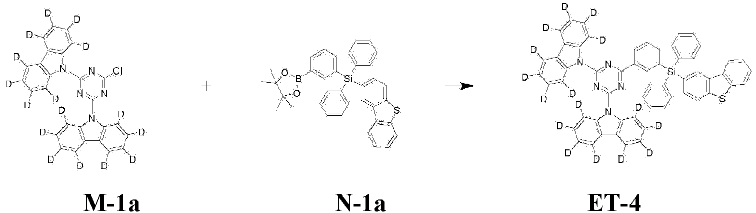

**ET-4** (yield 69%) was synthesized in the same manner as in Synthesis Example 3-1, except that **N-1a** and **M-1a** were used instead **of C-1a** and **C-1b,** respectively.
MS (MALDI-TOF): m/z 867.35 [M⁺]

### Synthesis Example 15: Synthesis of ET-5

### Synthesis Example 11-1: Synthesis of ET-5

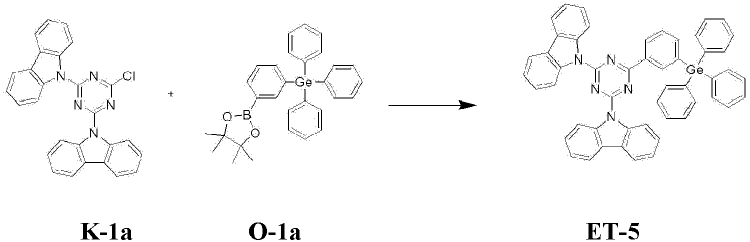

**ET-5** (yield 65%) was synthesized in the same manner as in Synthesis Example 3-1, except that **O-1a** and **K-1a** were used instead **of C-1a** and **C-1b,** respectively.
MS (MALDI-TOF): m/z 791.21 [M⁺]

### Synthesis Example 16: Synthesis of ET-6

### Synthesis Example 16-1: Synthesis of ET-6

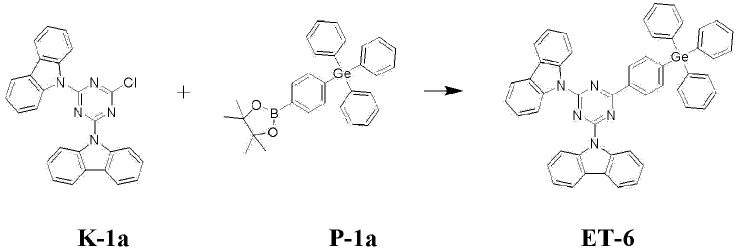

**ET-6** (yield 52%) was synthesized in the same manner as in Synthesis Example 3-1, except that **P-1a** and **K-1a** were used instead **of C-1a** and **C-1b,** respectively.
MS (MALDI-TOF): m/z 791.21 [M⁺]

### Examples 1-35: Fabrication of organic light emitting devices

ITO glass was patterned to have a light emitting area of 2 mm × 2 mm, followed by cleaning. After the cleaned ITO glass was mounted in a vacuum chamber, the base pressure was adjusted to 1 × 10⁻⁶ torr. HAT-CN and BCFN were used to sequentially form a 50 Å thick hole injecting layer and a 600 Å hole transport layer on the ITO glass, respectively. PBCz was used to form a 50 Å electron blocking layer. A mixture of the inventive first and second host compounds shown in Table 1 and 12 wt% of PBD as a dopant compound was used to form a 350 Å thick light emitting layer. Then, mSiTrz, a mixture of mSiTrz and Liq in a ratio of 1:1, Liq, and Al were used to sequentially form a 50 Å thick hole blocking layer, a 300 Å thick electron transport/injecting layer, a 10 Å thick electron injecting layer, and a 1,000 Å thick cathode on the light emitting layer, respectively, completing the fabrication of an organic light emitting device. The luminescent properties of the organic light emitting device were measured at 0.4 mA.

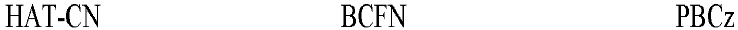

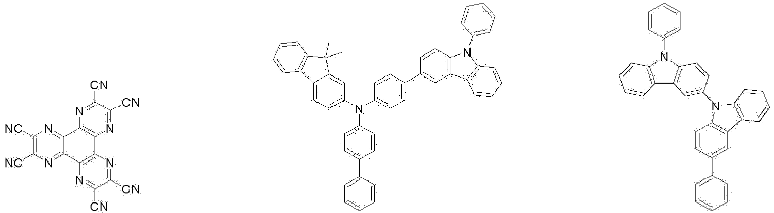

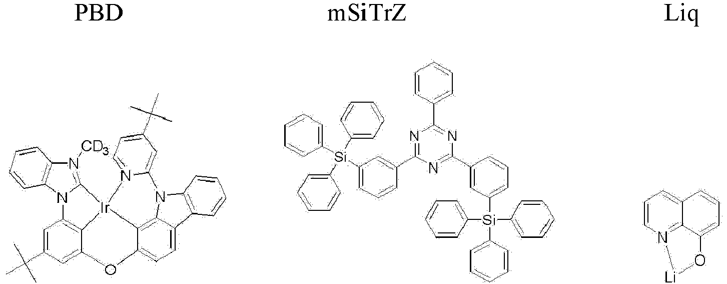

### Comparative Examples 1-21

Organic light emitting devices were fabricated in the same manner as in Examples 1-35, except that one **of RH-1** to **RH-3** was used as a host compound instead of the inventive host compounds. The luminescent properties of the organic light emitting devices were measured at 0.4 mA. The structures of **RH-1, RH-2,** and **RH-3** are as follow:

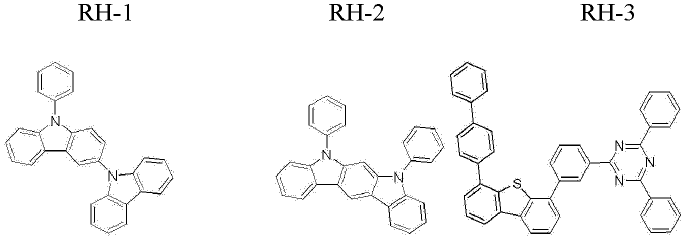

**Table 1**

| Example No. | Hosts (1:1) | | Driving voltage (V) | External quantum efficiency (%) | Color of light emission | Lifetime (T80, hr) |
|---|---|---|---|---|---|---|
| | First host | Second host | | | | |
| Example 1 | HT-1 | ET-1 | 4.4 | 17.2 | Blue | 115 |
| Example 2 | HT-2 | ET-1 | 4.5 | 17.1 | Blue | 105 |
| Example 3 | HT-3 | ET-1 | 4.5 | 16.9 | Blue | 101 |
| Example 4 | HT-4 | ET-1 | 4.5 | 17.3 | Blue | 125 |
| Example 5 | HT-5 | ET-1 | 4.6 | 17.0 | Blue | 102 |
| Example 6 | HT-6 | ET-1 | 4.7 | 16.9 | Blue | 100 |
| Example 7 | HT-7 | ET-1 | 4.5 | 17.2 | Blue | 95 |
| Example 8 | HT-8 | ET-1 | 4.7 | 17.0 | Blue | 98 |
| Example 9 | HT-9 | ET-1 | 4.6 | 17.1 | Blue | 106 |
| Example 10 | HT-10 | ET-1 | 4.5 | 16.9 | Blue | 135 |
| Example 11 | HT-1 | ET-2 | 4.5 | 17.1 | Blue | 112 |
| Example 12 | HT-2 | ET-2 | 4.6 | 17.0 | Blue | 103 |
| Example 13 | HT-4 | ET-2 | 4.5 | 17.2 | Blue | 121 |
| Example 14 | HT-7 | ET-2 | 4.6 | 17.1 | Blue | 96 |
| Example 15 | HT-10 | ET-2 | 4.6 | 16.7 | Blue | 130 |
| Example 16 | HT-1 | ET-3 | 4.5 | 17.3 | Blue | 120 |
| Example 17 | HT-2 | ET-3 | 4.5 | 17.2 | Blue | 111 |
| Example 18 | HT-4 | ET-3 | 4.5 | 17.5 | Blue | 130 |
| Example 19 | HT-7 | ET-3 | 4.6 | 17.3 | Blue | 99 |
| Example 20 | HT-10 | ET-3 | 4.5 | 17.1 | Blue | 140 |
| Example 21 | HT-1 | ET-4 | 4.4 | 17.3 | Blue | 117 |
| Example 22 | HT-2 | ET-4 | 4.5 | 17.2 | Blue | 108 |
| Example 23 | HT-4 | ET-4 | 4.5 | 17.4 | Blue | 128 |
| Example 24 | HT-7 | ET-4 | 4.5 | 17.3 | Blue | 98 |
| Example 25 | HT-10 | ET-4 | 4.5 | 17.1 | Blue | 137 |
| Example 26 | HT-1 | ET-5 | 4.4 | 17.3 | Blue | 110 |
| Example 27 | HT-2 | ET-5 | 4.5 | 17.2 | Blue | 100 |
| Example 28 | HT-4 | ET-5 | 4.5 | 17.3 | Blue | 121 |
| Example 29 | HT-7 | ET-5 | 4.5 | 17.2 | Blue | 95 |
| Example 30 | HT-10 | ET-5 | 4.5 | 17.0 | Blue | 129 |
| Example 31 | HT-1 | ET-6 | 4.6 | 17.0 | Blue | 110 |
| Example 32 | HT-2 | ET-6 | 4.7 | 16.9 | Blue | 101 |
| Example 33 | HT-4 | ET-6 | 4.6 | 17.1 | Blue | 118 |
| Example 34 | HT-7 | ET-6 | 4.7 | 17.0 | Blue | 97 |
| Example 35 | HT-10 | ET-6 | 4.7 | 16.7 | Blue | 127 |
| Comparative Example 1 | RH-1 | ET-1 | 5.1 | 15.3 | Blue | 65 |
| Comparative Example 2 | RH-1 | ET-2 | 5.2 | 15.2 | Blue | 60 |
| Comparative Example 3 | RH-1 | ET-3 | 5.1 | 15.5 | Blue | 70 |
| Comparative Example 4 | RH-1 | ET-4 | 5.3 | 15.4 | Blue | 69 |
| Comparative Example 5 | RH-1 | ET-5 | 5.4 | 15.3 | Blue | 60 |
| Comparative Example 6 | RH-1 | ET-6 | 5.5 | 15.2 | Blue | 58 |
| Comparative Example 7 | RH-2 | ET-1 | 5.5 | 14.7 | Blue | 55 |
| Comparative Example 8 | RH-2 | ET-2 | 5.7 | 14.5 | Blue | 52 |
| Comparative Example 9 | RH-2 | ET-3 | 5.6 | 14.8 | Blue | 59 |
| Comparative Example 10 | RH-2 | ET-4 | 5.7 | 14.9 | Blue | 59 |
| Comparative Example 11 | RH-2 | ET-5 | 5.6 | 14.5 | Blue | 53 |
| Comparative Example 12 | RH-2 | ET-6 | 5.8 | 14.4 | Blue | 51 |
| Comparative Example 13 | HT-1 | RH-3 | 5.4 | 14.9 | Blue | 57 |
| Comparative Example 14 | HT-2 | RH-3 | 5.6 | 14.7 | Blue | 54 |
| Comparative Example 15 | HT-4 | RH-3 | 5.2 | 15.0 | Blue | 63 |
| Comparative Example 16 | HT-7 | RH-3 | 5.7 | 14.8 | Blue | 53 |
| Comparative Example 17 | HT-10 | RH-3 | 5.5 | 15.0 | Blue | 60 |
| Comparative Example 18 | HT-1 | - | 5.8 | 11.2 | Blue | 23 |
| Comparative Example 19 | HT-7 | - | 5.9 | 11.0 | Blue | 15 |
| Comparative Example 20 | RH-1 | RH-3 | 5.7 | 12.4 | Blue | 42 |
| Comparative Example 21 | RH-2 | RH-3 | 5.9 | 12.1 | Blue | 37 |

As can be seen from the results in Table 1, the organic light emitting devices of Examples 1-35, each of which employed the inventive host compounds for the light emitting layer, had high quantum efficiencies and improved life characteristics at low driving voltages compared to the organic light emitting devices of Comparative Examples 1-21, each of which employed the compound that is widely used in the art and whose specific structure is contrasted with those of the inventive compounds. These results concluded that the use of the inventive compounds makes the organic light emitting devices highly efficient and long lasting.

### Examples 36-50: Fabrication of organic light emitting devices

Organic light emitting devices used were fabricated in the same manner as in Examples 1-35, except that a mixture of the inventive host compounds shown in Table 2 and 0.5 wt% of the inventive dopant compound BD-1 was used. The luminescence properties of the organic light emitting devices were measured at 0.4 mA.

### Comparative Examples 22-34

Organic light emitting devices were fabricated in the same manner as in Examples 36-50, except that one of **RH-1** to **RH-3** was used as a host compound instead of the inventive host compounds. The luminescent properties of the organic light emitting devices were measured at 0.4 mA.

**Table 2**

| Example No. | Fist host | Second host | Driving voltage (V) | External quantum efficiency (%) | Color of light emission | Lifetime (T80, hr) |
|---|---|---|---|---|---|---|
| Example 36 | HT-1 | ET-1 | 4.3 | 17.3 | Blue | 117 |
| Example 37 | HT-2 | ET-1 | 4.4 | 17.2 | Blue | 105 |
| Example 38 | HT-4 | ET-1 | 4.5 | 17.4 | Blue | 126 |
| Example 39 | HT-7 | ET-1 | 4.4 | 17.3 | Blue | 98 |
| Example 40 | HT-10 | ET-1 | 4.5 | 17.0 | Blue | 138 |
| Example 41 | HT-1 | ET-4 | 4.4 | 17.4 | Blue | 119 |
| Example 42 | HT-2 | ET-4 | 4.5 | 17.3 | Blue | 110 |
| Example 43 | HT-4 | ET-4 | 4.5 | 17.5 | Blue | 131 |
| Example 44 | HT-7 | ET-4 | 4.5 | 17.4 | Blue | 100 |
| Example 45 | HT-10 | ET-4 | 4.5 | 17.1 | Blue | 140 |
| Example 46 | HT-1 | ET-5 | 4.4 | 17.4 | Blue | 111 |
| Example 47 | HT-2 | ET-5 | 4.4 | 17.2 | Blue | 102 |
| Example 48 | HT-4 | ET-5 | 4.3 | 17.5 | Blue | 122 |
| Example 49 | HT-7 | ET-5 | 4.5 | 17.3 | Blue | 92 |
| Example 50 | HT-10 | ET-5 | 4.5 | 17.2 | Blue | 131 |
| Comparative Example 22 | RH-1 | ET-1 | 5.1 | 15.8 | Blue | 66 |
| Comparative Example 23 | RH-1 | ET-4 | 5.2 | 15.9 | Blue | 70 |
| Comparative Example 24 | RH-1 | ET-5 | 5.4 | 15.8 | Blue | 61 |
| Comparative Example 25 | RH-2 | ET-1 | 5.5 | 15.1 | Blue | 56 |
| Comparative Example 26 | RH-2 | ET-4 | 5.6 | 15.3 | Blue | 61 |
| Comparative Example 27 | RH-2 | ET-5 | 5.5 | 14.9 | Blue | 54 |
| Comparative Example 28 | HT-1 | RH-3 | 5.3 | 15.3 | Blue | 58 |
| Comparative Example 29 | HT-2 | RH-3 | 5.5 | 15.1 | Blue | 56 |
| Comparative Example 30 | HT-4 | RH-3 | 5.1 | 15.4 | Blue | 64 |
| Comparative Example 31 | HT-7 | RH-3 | 5.7 | 15.1 | Blue | 54 |
| Comparative Example 32 | HT-10 | RH-3 | 5.4 | 15.4 | Blue | 61 |
| Comparative Example 33 | RH-1 | RH-3 | 5.6 | 12.7 | Blue | 45 |
| Comparative Example 34 | RH-2 | RH-3 | 5.8 | 12.1 | Blue | 40 |

As can be seen from the results in Table 2, the organic light emitting devices of Examples 36-50, each of which employed the inventive host compounds for the light emitting layer, had high quantum efficiencies and improved life characteristics at low driving voltages compared to the organic light emitting devices of Comparative Examples 22-34, each of which employed the compound that is widely used in the art and whose specific structure is contrasted with those of the inventive compounds. These results concluded that the use of the inventive compounds makes the organic light emitting devices highly efficient and long lasting.

## Claims

1. An organic light emitting device comprising a first electrode, a second electrode opposite to the first electrode, and one or more organic layers interposed between the first and second electrodes wherein one of the organic layers is a light emitting layer comprising hosts and dopants and at least one of the hosts is selected from organic compounds represented by Formulas 1 and 2: 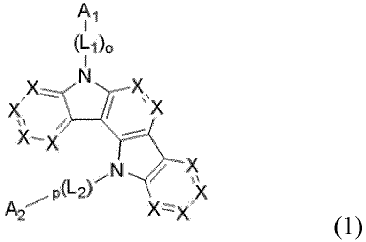
wherein the moieties X are the same as or different from each other and are each independently N or CR₁, the groups R₁ are the same as or different from each other and are each independently selected from hydrogen, deuterium, substituted or unsubstituted C₁-C₃₀ alkyl, substituted or unsubstituted C₆-C₅₀ aryl, substituted or unsubstituted C₂-C₅₀ heteroaryl, and cyclic groups in which a substituted or unsubstituted C₃-C₃₀ aliphatic ring and a C₅-C₃₀ aromatic ring are fused together, with the proviso that adjacent ones of the groups R₁ are optionally linked to each other to form an alicyclic or aromatic monocyclic or polycyclic ring, A₁ and A₂ are the same as or different from each other and are each independently selected from substituted or unsubstituted C₆-C₅₀ aryl, substituted or unsubstituted C₂-C₅₀ heteroaryl, and cyclic groups in which a substituted or unsubstituted C₃-C₃₀ aliphatic ring and a C₅-C₃₀ aromatic ring are fused together, L₁ and L₂ are the same as or different from each other and each independently represent a single bond or are each independently selected from substituted or unsubstituted C₆-C₃₀ arylene, substituted or unsubstituted C₂-C₃₀ heteroarylene, and divalent cyclic groups in which a substituted or unsubstituted C₃-C₂₄ aliphatic ring and a C₅-C₂₄ aromatic ring are fused together, o and p are each independently an integer of 1 or 2, provided that when o and p are integers greater than or equal to 2, the linkers L₁ and L₂ are the same as or different from each other, respectively, 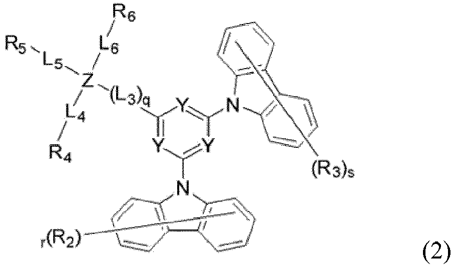
wherein the moieties Y are the same as or different from each other and are each independently N or CR₇, with the proviso that at least one of the moieties Y is N, Z is Si or Ge, R₂ to R₆ are the same as or different from each other and are each independently selected from hydrogen, deuterium, substituted or unsubstituted C₁-C₃₀ alkyl, substituted or unsubstituted C₆-C₅₀ aryl, substituted or unsubstituted C₂-C₅₀ heteroaryl, and cyclic groups in which a substituted or unsubstituted C₃-C₃₀ aliphatic ring and a C₅-C₃₀ aromatic ring are fused together, r and s are integers of 8, the groups R₂ and R₃ are the same as or different from each other, respectively, with the proviso that adjacent ones of the groups R₂ are optionally linked to each other to form an alicyclic or aromatic monocyclic or polycyclic ring, with the proviso that adjacent ones of the groups R₃ are optionally linked to each other to form an alicyclic or aromatic monocyclic or polycyclic ring, L₃ to L₆ are the same as or different from each other and each independently represent a single bond or are each independently selected from substituted or unsubstituted C₆-C₃₀ arylene, substituted or unsubstituted C₂-C₃₀ heteroarylene, and divalent cyclic groups in which a substituted or unsubstituted C₃-C₂₄ aliphatic ring and a C₅-C₂₄ aromatic ring are fused together, q is an integer of 1 or 2, provided that when q is an integer greater than or equal to 2, the linkers L₃ are the same as or different from each other, the "substituted" in the definitions of X, A₁, A₂, and L₁ and L₂ in Formula 1 and Y, R₂ to R₆, and L₃ to L₆ in Formula 2 indicating substitution with one or more substituents selected from deuterium, C₁-C₂₄ alkyl, C₁-C₂₄ haloalkyl, C₂-C₂₄ alkenyl, C₂-C₂₄ alkynyl, C₃-C₃₀ cycloalkyl, C₁-C₂₄ heteroalkyl, C₆-C₃₀ aryl, C₇-C₃₀ arylalkyl, C₇-C₃₀ alkylaryl, C₂-C₃₀ heteroaryl, C₂-C₃₀ heteroarylalkyl, C₂-C₃₀ heteroarylalkyl, cyclic groups in which a substituted or unsubstituted C₃-C₂₄ aliphatic ring and a C₅-C₂₄ aromatic ring are fused together, C₁-C₂₄ alkoxy, C₁-C₃₀ amine, C₁-C₃₀ silyl, C₁-C₃₀ germanium, C₆-C₂₄ aryloxy, C₆-C₂₄ arylthionyl, cyano, halogen, hydroxyl, and nitro, or a combination thereof, provided that when substituted with two or more substituents, the substituents are identical to or different from each other, the "unsubstituted" in the same definition indicating having no substituent, and one or more hydrogen atoms in each of the substituents being optionally replaced by deuterium atoms.

2. The organic light emitting device according to claim 1, wherein the moieties X in Formula 1 are all CR₁.

3. The organic light emitting device according to claim 1, wherein the organic compound represented by Formula 1 is deuterated.

4. The organic light emitting device according to claim 1, wherein the compound represented by Formula 1 is selected from the following compounds:

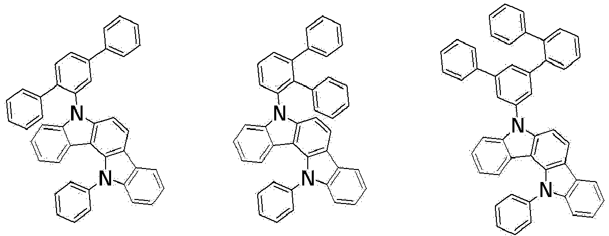

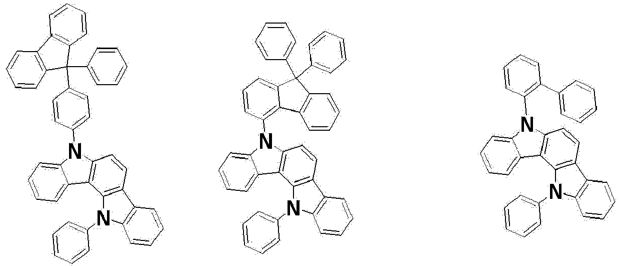

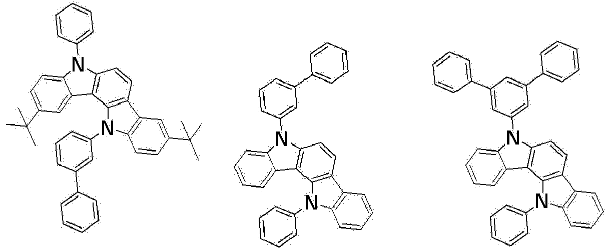

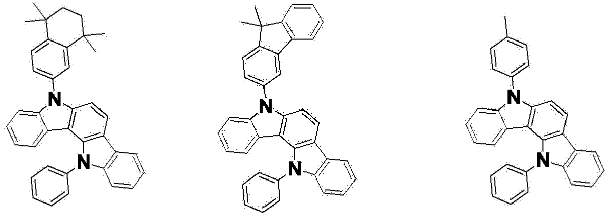

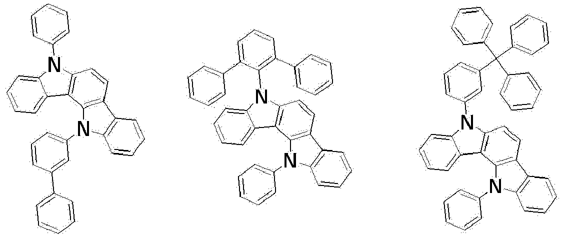

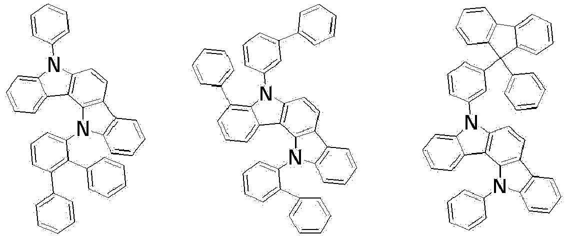

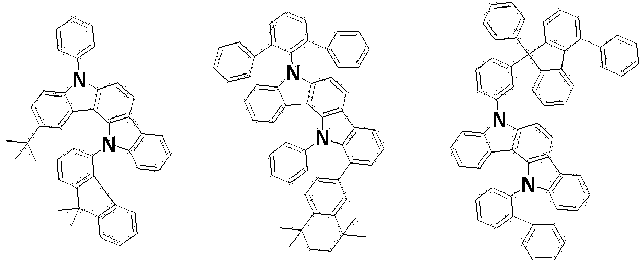

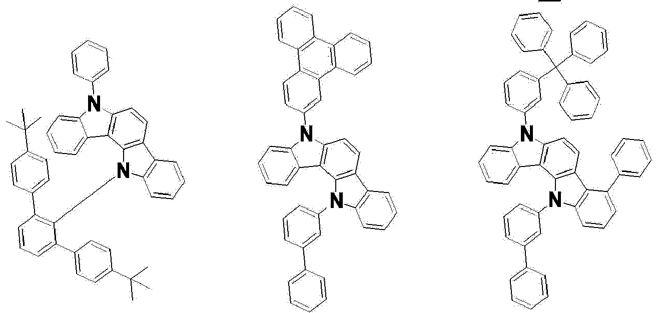

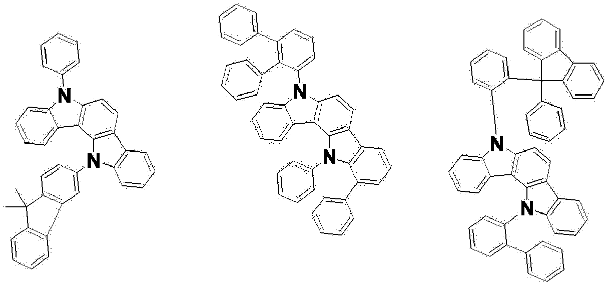

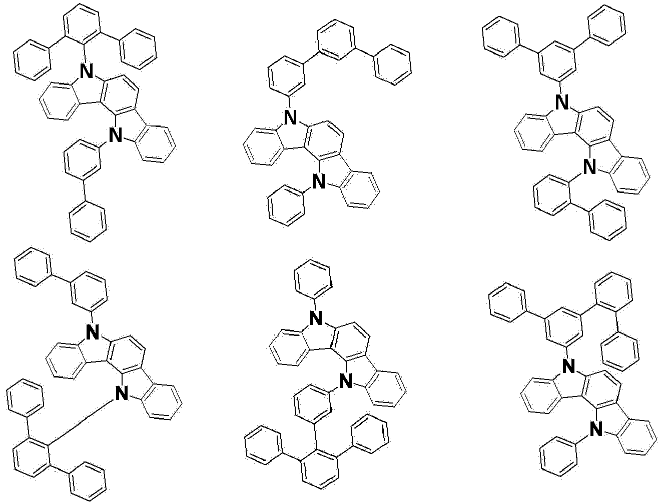

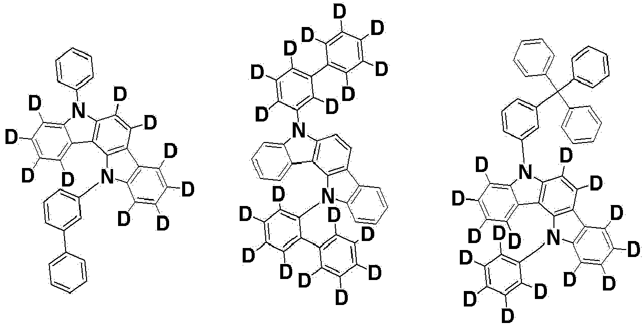

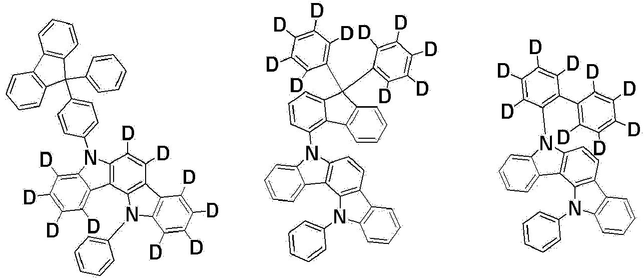

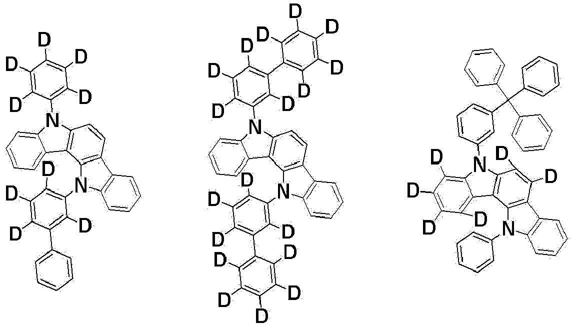

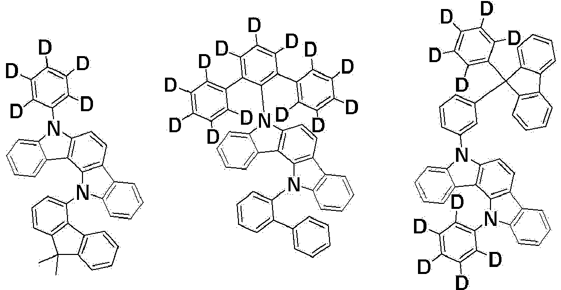

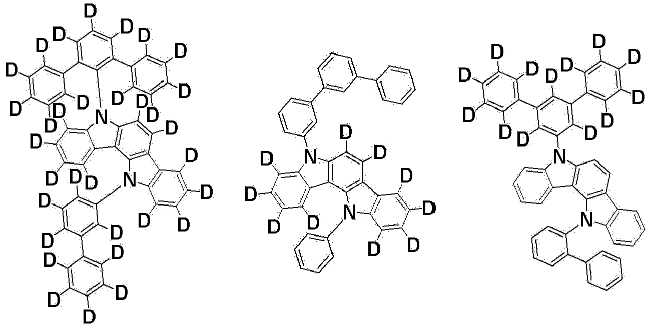

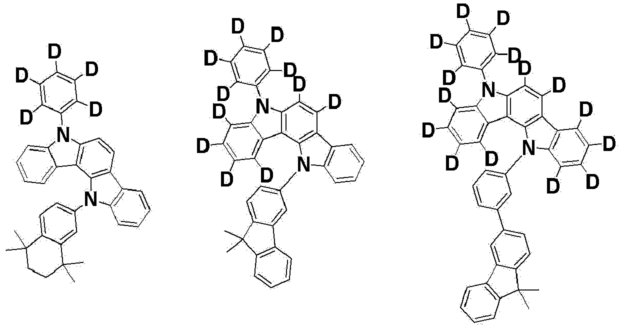

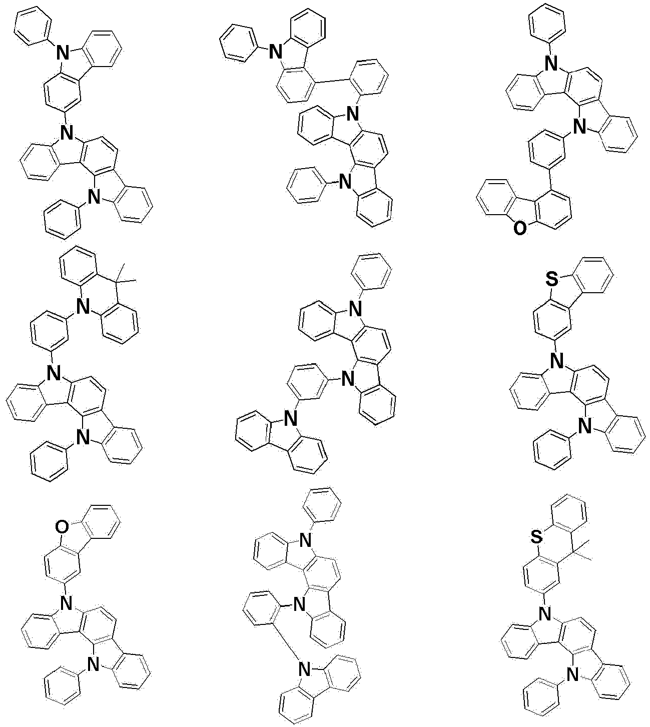

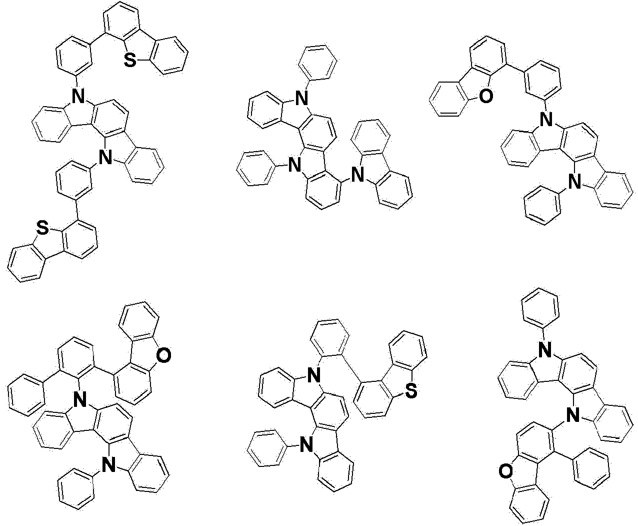

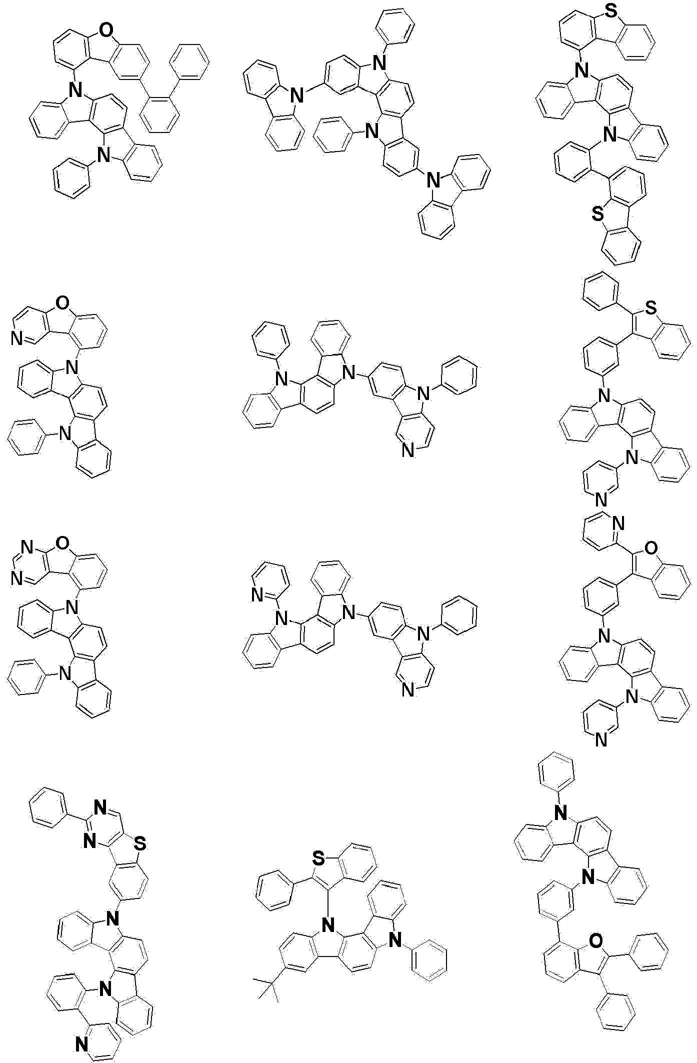

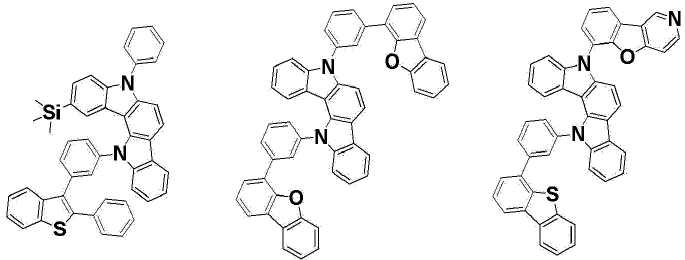

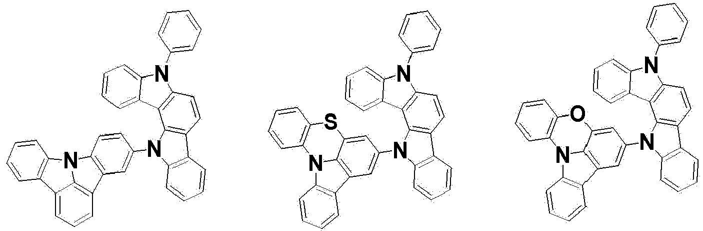

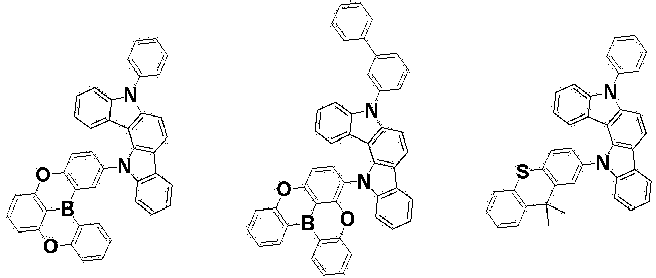

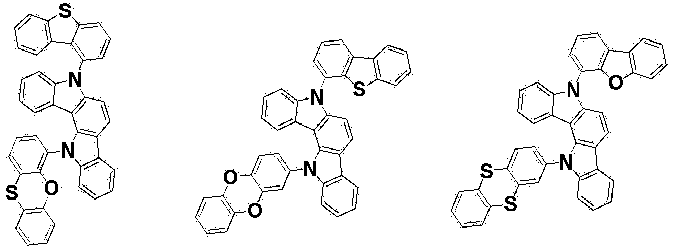

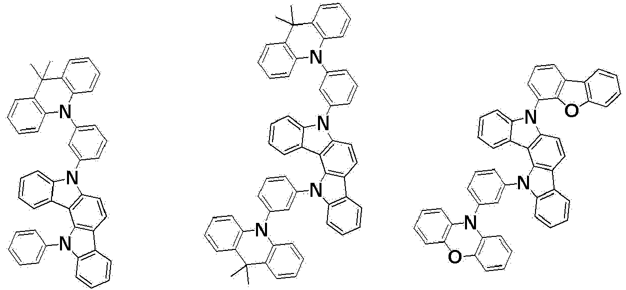

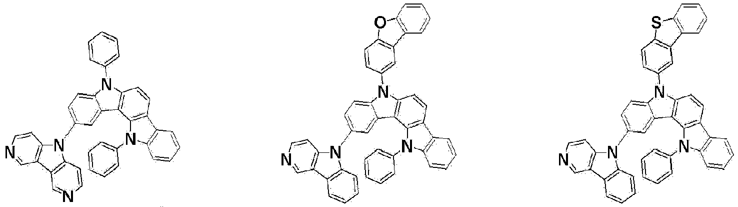

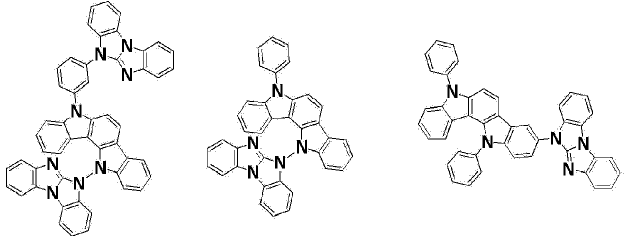

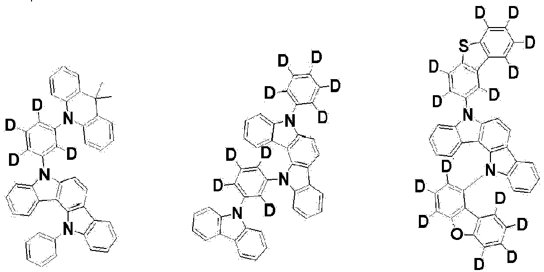

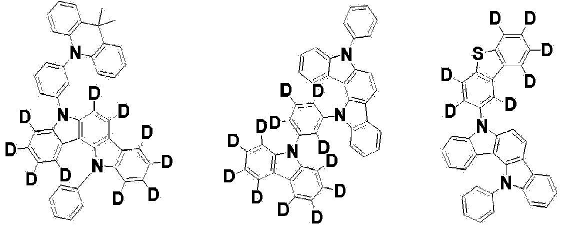

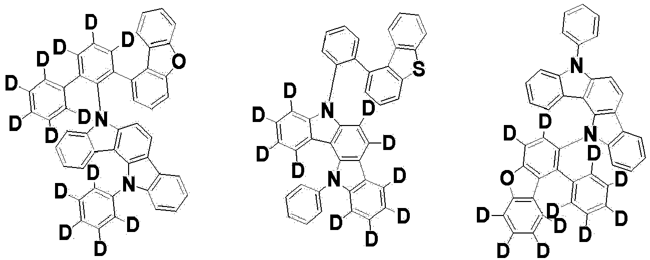

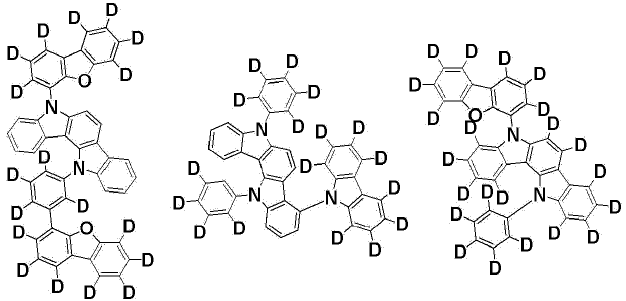

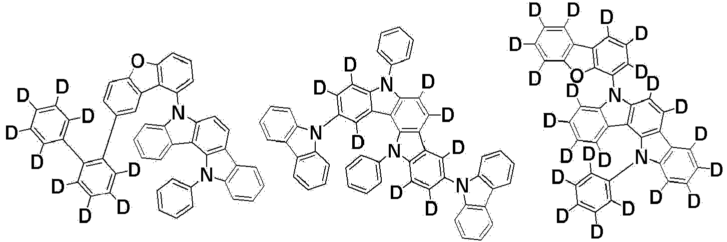

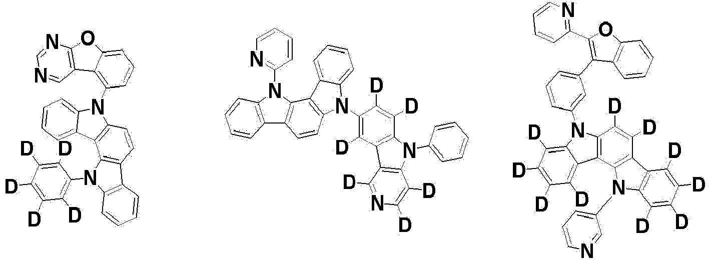

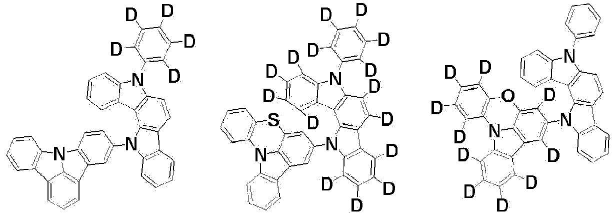

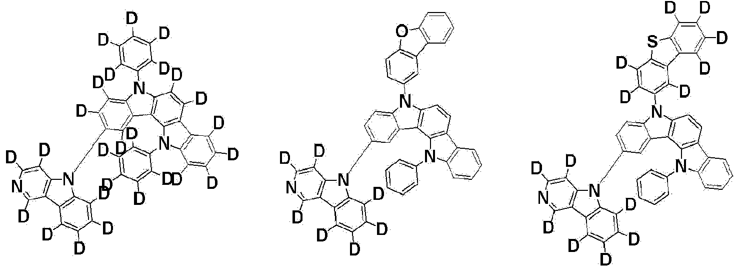

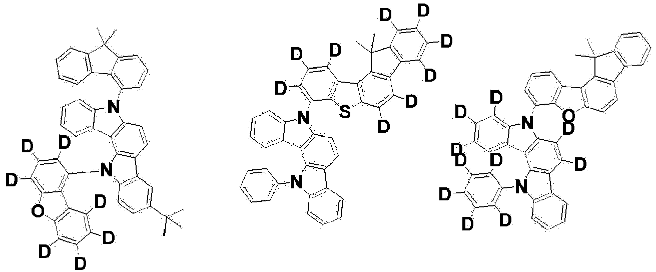

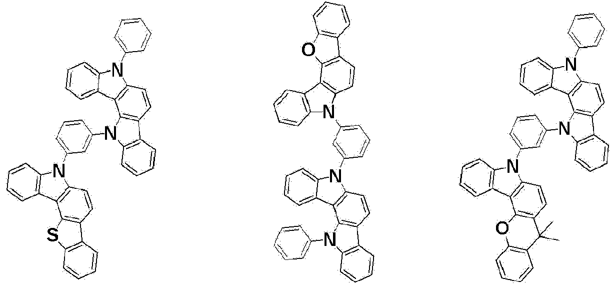

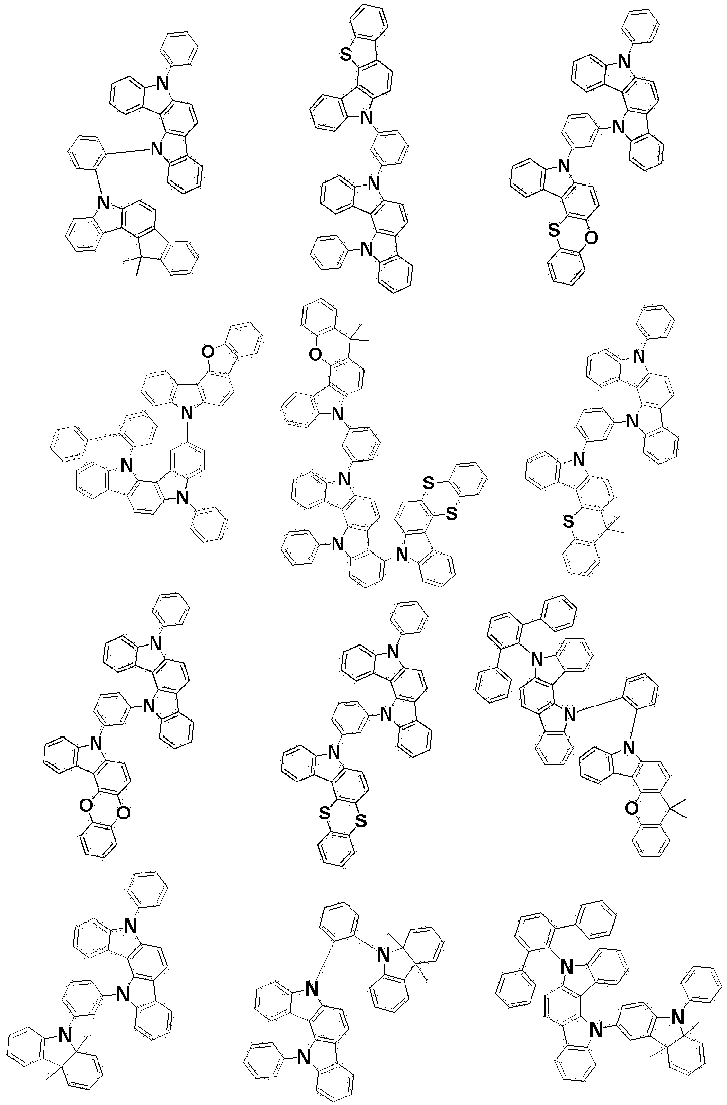

5. The organic light emitting device according to claim 1, wherein the moieties Y in Formula 2 are all N.

6. The organic light emitting device according to claim 1, wherein q in Formula 2 is an integer of 1 and L₃ in Formula 2 is substituted or unsubstituted C₆-C₂₀ arylene.

7. The organic light emitting device according to claim 1, wherein R₄ to R₆ in Formula 2 are the same as or different from each other and are each independently substituted or unsubstituted C₆-C₂₀ aryl.

8. The organic light emitting device according to claim 1, wherein Z in Formula 2is Si.

9. The organic light emitting device according to claim 1, wherein the organic compound represented by Formula 2 is deuterated.

10. The organic light emitting device according to claim 1, wherein the compound represented by Formula 2 is selected from the following compounds:

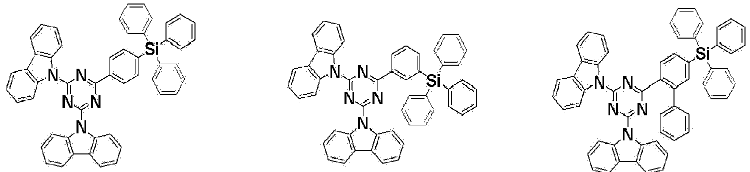

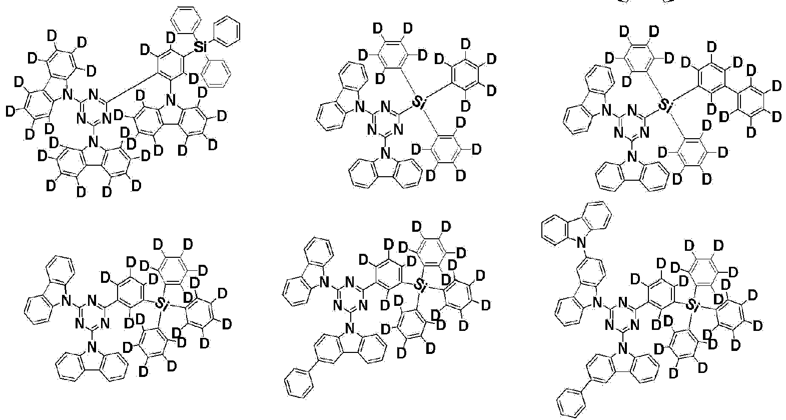

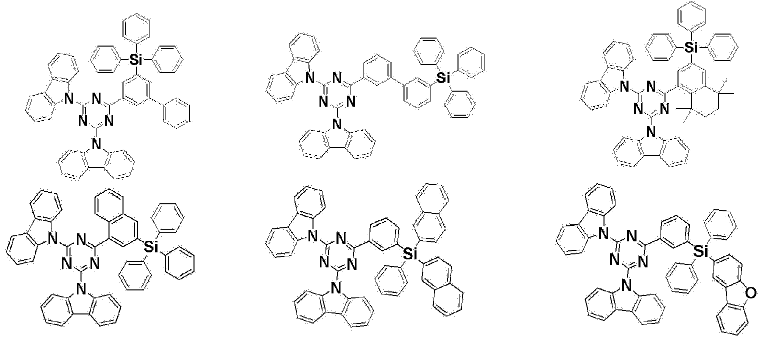

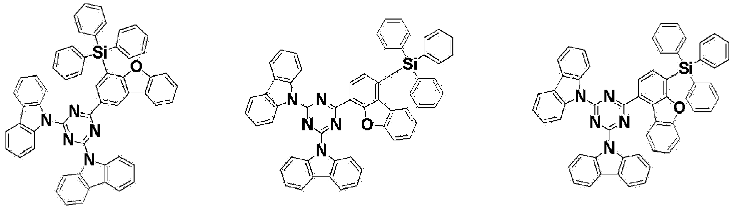

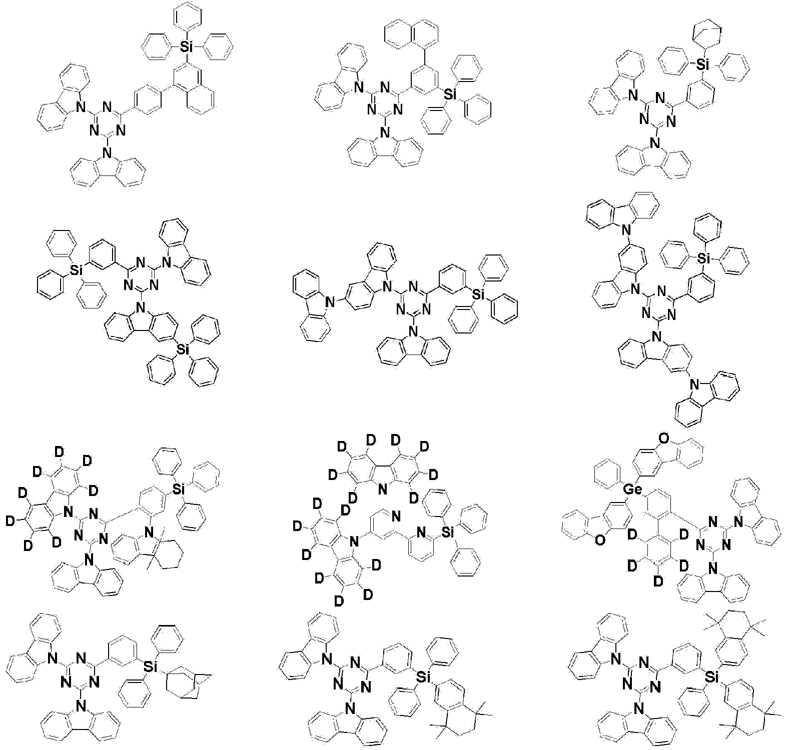

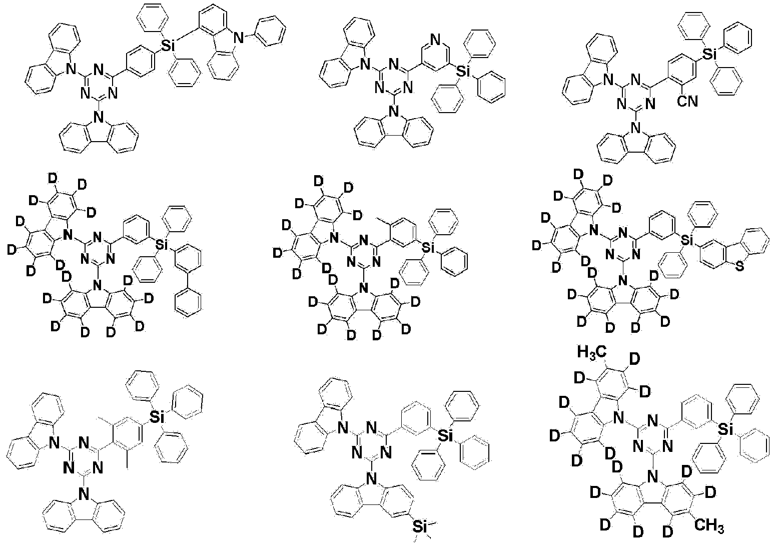

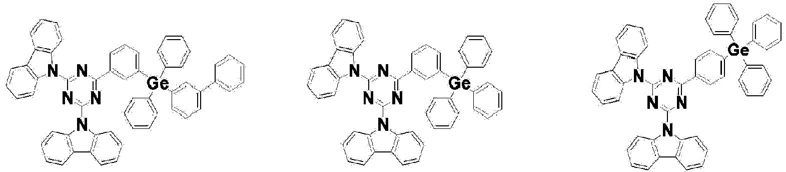

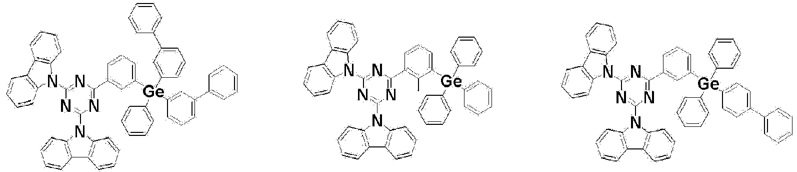

11. The organic light emitting device according to claim 1, wherein the organic compounds represented by Formulas 1 and 2 are used as hosts that emit blue phosphorescence.

12. The organic light emitting device according to claim 1, wherein one of the dopants is least one organometallic compound.

13. The organic light emitting device according to claim 1, wherein the light emitting layer further comprises one or more dopants other than the organometallic compound and wherein the two or more dopants are mixed or stacked in the light emitting layer.

14. The organic light emitting device according to claim 13, wherein one of the additional dopants is a polycyclic compound represented by Formula 3: 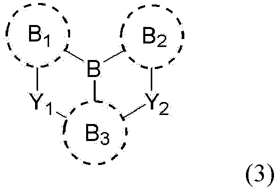 wherein Y₁ and Y₂ are the same as or different from each other and are each independently selected from O, S, NR₁₁, CR₁₂R₁₃, SiR₁₄R₁₅, and GeR₁₆R₁₇, B₁ to B₃ are the same as or different from each other and are each independently selected from substituted or unsubstituted C₆-C₃₀ aromatic hydrocarbon rings, substituted or unsubstituted C₃-C₃₀ aliphatic hydrocarbon rings, substituted or unsubstituted C₂-C₃₀ aromatic heterocyclic rings, substituted or unsubstituted C₂-C₃₀ aliphatic heterocyclic rings, and cyclic groups in which a substituted or unsubstituted C₃-C₂₄ aliphatic ring and a C₅-C₂₄ aromatic ring are fused together, R₁₁ to R₁₇ are the same as or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, cyclic groups in which a substituted or unsubstituted C₃-C₃₀ aliphatic ring and a C₅-C₃₀ aromatic ring are fused together, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted germanium, nitro, cyano, and halogen, with the proviso that each of R₁₁ to R₁₇ is optionally linked to one or more of the B₁ to B₃ rings to form an alicyclic or aromatic monocyclic or polycyclic ring, R₁₂ and R₁₃ are optionally linked to each other to form an alicyclic or aromatic monocyclic or polycyclic ring, R₁₄ and R₁₅ are optionally linked to each other to form an alicyclic or aromatic monocyclic or polycyclic ring, and R₁₆ and R₁₇ are optionally linked to each other to form an alicyclic or aromatic monocyclic or polycyclic ring, the "substituted" in the definitions of Y₁, Y₂, and B₁ to B₃ in Formula 3 indicating substitution with one or more substituents selected from deuterium, C₁-C₂₄ alkyl, C₂-C₂₄ alkenyl, C₂-C₂₄ alkynyl, C₃-C₃₀ cycloalkyl, C₁-C₂₄ heteroalkyl, C₆-C₃₀ aryl, C₇-C₃₀ arylalkyl, C₇-C₃₀ alkylaryl, C₂-C₃₀ heteroaryl, C₂-C₃₀ heteroarylalkyl, cyclic groups in which a substituted or unsubstituted C₃-C₂₄ aliphatic ring and a C₅-C₂₄ aromatic ring are fused together, C₁-C₂₄ alkoxy, C₁-C₃₀ amine, C₁-C₃₀ silyl, C₁-C₃₀ germanium, C₆-C₂₄ aryloxy, C₆-C₂₄ arythionyl, cyano, halogen, hydroxyl, and nitro, or a combination thereof, provided that when substituted with two or more substituents, the substituents are identical to or different from each other, the "unsubstituted" in the same definition indicating having no substituent, and one or more hydrogen atoms in each of the substituents being optionally replaced by deuterium atoms.

15. The organic light emitting device according to claim 1, wherein the organic light emitting device is used in a display or lighting system selected from flat panel displays, flexible displays, monochromatic flat panel lighting systems, white flat panel lighting systems, flexible monochromatic lighting systems, flexible white lighting systems, displays for automotive applications, displays for virtual reality, and displays for augmented reality.
